# EUROPEAN PATENT APPLICATION

(11) **EP 4 819 588 A1**
(43) Date of publication of application: **07.10.2026**
(21) Application number: 24906096.3
(22) Date of filing: 04.12.2024
(51) Int. Cl.: H04L 69/04

(54) **DATA COMPRESSION METHOD AND APPARATUS**

(30) Priority: 21.12.2023 CN 202311777271
(71) Applicant: Huawei Technologies Co., Ltd., Shenzhen, Guangdong 518129 (CN)
(72) Inventor: MA, Mengyao, Shenzhen, Guangdong 518129 (CN); LI, Jiahui, Shenzhen, Guangdong 518129 (CN); LU, Jianmin, Shenzhen, Guangdong 518129 (CN); DU, Yinggang, Shenzhen, Guangdong 518129 (CN)
(74) Representative: Maiwald GmbH
(86) International application number: PCT/CN2024/136741
(87) International publication number: WO 2025/130612

(57) **Abstract**

This application provides a data compression method and apparatus. The method includes: compressing first data by using N preconfigured data processing modules, where the compression includes at least one processing operation, a combination of functions of the N data processing modules includes the at least one processing operation, the N data processing modules are determined based on the first data, a task scenario, and/or a capability of a first device, and N is a natural number greater than 0; and sending the compressed first data.

## Description

This application claims priority to Chinese Patent Application No. 202311777271.3, filed with the China National Intellectual Property Administration on December 21, 2023 and entitled "DATA COMPRESSION METHOD AND APPARATUS", which is incorporated herein by reference in its entirety.

### TECHNICAL FIELD

This application relates to the communication field, and specifically, to a data compression method and apparatus.

### BACKGROUND

With growing diversity of wireless communication application scenarios, a large amount of native data is generated during wireless communication. Compressing to-be-transmitted data can reduce transmission overheads.

In existing communication systems, different compression procedures are used for different types of data, and there is no unified standard procedure. Consequently, standardization costs are high, and data compression is mostly performed at the application layer.

### SUMMARY

This application provides a data compression method and apparatus, so that to-be-transmitted data can be compressed at a physical layer by using a data processing module, and a used data processing module and parameter can be flexibly configured based on a data type, a task scenario, and the like, to ensure compression performance while reducing standardization costs.

According to a first aspect, a data compression method is provided and is applied to a first device, for example, a network device, a terminal device, a chip, a chip system, a hardware circuit, a software module, or a combination of a hardware circuit and a software module.

The method may include: compressing first data by using N preconfigured data processing modules, where the compression corresponds to at least one data processing operation, a combination of functions of the N data processing modules includes the at least one data processing operation, the N data processing modules are determined based on the first data, a task scenario, and/or a capability of a first device, and N is a natural number greater than 0; and sending the compressed first data.

Optionally, determining the N data processing modules based on the first data includes: determining the N data processing modules based on a data type of the first data, a data volume of the first data, and/or the like.

That the N data processing modules are determined based on the task scenario may be understood as that different task scenarios have different data compression requirements. For example, when a requirement for a delay, a requirement for data compression quality, and the like are different, used data processing modules are also not completely the same.

Optionally, determining the N data processing modules based on the capability of the first device includes: determining the N data processing modules based on data processing modules supported by the first device, available computational power of the first device, and the like.

According to the foregoing solution, a plurality of data processing modules are preconfigured to compress the to-be-transmitted first data, and the data processing modules are invoked based on the data type of the first data, the task scenario, and/or the capability of the first device to compress data of various types, so that resources required for formulating compression procedures can be saved, thereby enabling more flexible configuration of the data processing modules and improving compression efficiency.

With reference to the first aspect, in some implementations of the first aspect, the data processing modules are deployed at a physical layer.

Alternatively, the data processing modules may be deployed at an upper layer or an application layer of a protocol stack.

With reference to the first aspect, in some implementations of the first aspect, compressing the first data by using the N preconfigured data processing modules includes: compressing the first data by using the N data processing modules based on a first sequence and a first compression parameter. The first sequence is a sequence of processing data by the N data processing modules, and the first compression parameter is a parameter used by the N data processing modules to process data.

With reference to the first aspect, in some implementations of the first aspect, the first sequence and/or the first compression parameter is determined based on the first data, the task scenario, and/or the capability of the first device.

According to the foregoing solution, an execution sequence and parameters of the data processing modules are determined based on the data type of the first data, the task scenario, and/or the capability of the first device, thereby enabling more flexible configuration of the data processing modules and saving resources required for formulating the compression procedures while ensuring compression performance.

With reference to the first aspect, in some implementations of the first aspect, the N data processing modules are data processing modules in a preconfigured data processing module pool, and the data processing module pool includes the N data processing modules.

It should be understood that the data processing module pool includes a plurality of data processing modules, and the plurality of data processing modules include the N data processing modules.

Optionally, in addition to the N data processing modules, the data processing module pool further includes other data processing modules.

With reference to the first aspect, in some implementations of the first aspect, the data processing module pool further includes an index of each of the N data processing modules.

Optionally, the data processing module pool further includes indexes of other data processing modules in addition to the N data processing modules.

According to the foregoing solution, the data processing module pool includes a plurality of data processing modules and corresponding indexes, which facilitates configuration indication for compressing different types of data.

With reference to the first aspect, in some implementations of the first aspect, the data processing module pool includes M data processing module sets, the data processing module set includes at least one data processing module, the N data processing modules are data processing modules in the M data processing module sets, and data processing modules in each of the M data processing module sets perform a same data processing function.

With reference to the first aspect, in some implementations of the first aspect, the N data processing modules that compress the first data are determined from the data processing module pool based on the first data, the task scenario, and/or the capability of the first device.

According to the foregoing solution, the data processing modules in the data processing module pool are classified based on functions, which facilitates configuration of the data processing modules.

With reference to the first aspect, in some implementations of the first aspect, the method further includes: receiving or sending first information, where the first information is used to determine the data processing module pool.

Optionally, receiving the first information includes: receiving the first information sent by the network device or a second device.

Optionally, sending the first information includes: sending the first information to the network device or the second device.

Optionally, the second device and the network device are a same device.

According to the foregoing solution, the first device receives the first information to determine the data processing module pool, or the first device sends, to another device, the first information used to determine the data processing module pool.

With reference to the first aspect, in some implementations of the first aspect, receiving or sending the first information includes: receiving the first information, where the first information is data processing module pool configuration information or capability information of the second device.

According to the foregoing solution, the first device receives the data processing module pool configuration information or the capability information of the second device, to determine the data processing module pool.

With reference to the first aspect, in some implementations of the first aspect, receiving or sending the first information includes: sending the first information, where the first information is data processing module pool configuration information or capability information of the first device.

According to the foregoing solution, the first device sends the data processing module pool configuration information or the capability information of the first device to another device, so that the another device determines the data processing module pool of the first device.

With reference to the first aspect, in some implementations of the first aspect, the method further includes: determining, based on first configuration information, the N data processing modules that compress the first data, the first sequence, and/or the first compression parameter. The first sequence is a sequence of processing data by the N data processing modules, and the first compression parameter is a parameter used by the N data processing modules to process data.

According to the foregoing solution, the first device determines configuration of the data processing modules based on the first configuration information, and invokes corresponding data processing modules to compress data.

With reference to the first aspect, in some implementations of the first aspect, the method further includes: receiving or sending the first configuration information.

Optionally, receiving the first configuration information includes: receiving the first configuration information sent by the network device or the second device.

Optionally, sending the first configuration information includes: sending the first configuration information to the network device or the second device.

Optionally, the second device and the network device are a same device.

According to the foregoing solution, the first device receives the first configuration information, to determine a data processing module configuration; or after determining the first configuration information and the data processing module configuration, the first device notifies the second device of the first configuration information.

With reference to the first aspect, in some implementations of the first aspect, the first configuration information includes indexes of N data processing modules corresponding to the first data, and the indexes of the N data processing modules are used to determine the N data processing modules and/or the first sequence.

According to the foregoing solution, the first configuration information indicates the data processing module configuration by using the index, thereby saving signaling resources.

With reference to the first aspect, in some implementations of the first aspect, the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

According to the foregoing solution, the first configuration information includes data processing module configurations corresponding to data of a plurality of types, and the data processing modules may be flexibly configured as required based on requirements of data of different types.

With reference to the first aspect, in some implementations of the first aspect, the method further includes: determining, based on second configuration information, X data processing modules that compress third data, a third sequence, and/or a third compression parameter. The third sequence is a sequence of processing data by the X data processing modules, the third compression parameter is a parameter used by the X data processing modules to process data, and the third data and the first data are data of a same type or data of a same application. The X data processing modules are not completely the same as the N data processing modules, and/or the third sequence is not completely the same as the first sequence, and/or the first compression parameter is not completely the same as the third compression parameter.

According to the foregoing solution, the data processing module configuration of the first data is updated, thereby ensuring validity of the data processing module configuration.

With reference to the first aspect, in some implementations of the first aspect, the method further includes: compressing the third data by using the X data processing modules.

With reference to the first aspect, in some implementations of the first aspect, compressing the third data by using the X data processing modules includes: compressing the third data by using the X data processing modules based on the third sequence and the third compression parameter.

According to the foregoing solution, when a condition such as the task scenario changes, the data processing module configuration for compressing data is updated, so that the data processing modules are flexibly configured based on a specific situation.

With reference to the first aspect, in some implementations of the first aspect, the method further includes: receiving or sending the second configuration information.

Optionally, receiving the second configuration information includes: receiving the second configuration information sent by the network device or the second device.

Optionally, sending the second configuration information includes: sending the second configuration information to the network device or the second device.

Optionally, the second device and the network device are a same device.

According to the foregoing solution, the first device receives the second configuration information, to determine an updated data processing module configuration; or after updating the data processing module configuration and determining the second configuration information, the first device notifies the second device of the second configuration information.

With reference to the first aspect, in some implementations of the first aspect, the second configuration information includes indexes of the X data processing modules corresponding to the first data, and the indexes of the X data processing modules are used to determine the X data processing modules and/or the third sequence.

According to the foregoing solution, the second configuration information indicates the data processing module configuration by using the index, thereby saving signaling resources.

With reference to the first aspect, in some implementations of the first aspect, the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

According to the foregoing solution, the second configuration information includes updated data processing module configurations corresponding to data of a plurality of types, and the data processing modules may be flexibly configured as required based on requirements of data of different types.

With reference to the first aspect, in some implementations of the first aspect, the method further includes: sending first training data, where the first training data includes training data corresponding to the first data.

According to the foregoing solution, the training data related to data compression is sent to the network device or the second device, which helps achieve more accurate configuration of the data processing modules and improves compression efficiency.

With reference to the first aspect, in some implementations of the first aspect, the method further includes: receiving first request information, where the first request information is used to request to obtain the first training data.

According to a second aspect, a data compression method is provided and is applied to a second device or a network device, or may be applied to a module (a chip, a circuit, or the like) in the second device or the network device. The following describes the method in this application by using the network device as an example.

The method may include: sending first configuration information. The first configuration information is used to determine N preconfigured data processing modules that compress first data, a first sequence, and/or a first compression parameter, the compression corresponds to at least one data processing operation, a combination of functions of the N data processing modules includes the at least one data processing operation, N is a natural number greater than 0, the first sequence is a sequence of processing data by the N data processing modules, the first compression parameter is a parameter used by the N data processing modules to process data, and the N data processing modules, the first sequence, and/or the first compression parameter are/is determined based on the first data, a task scenario, and/or a capability of a first device.

Optionally, determining the N data processing modules based on the first data includes: determining the N data processing modules based on a data type of the first data, a data volume of the first data, and/or the like.

That the N data processing modules are determined based on the task scenario may be understood as that different task scenarios have different data compression requirements. For example, when a requirement for a delay, a requirement for data compression quality, and the like are different, used data processing modules are also not completely the same.

Optionally, determining the N data processing modules based on the capability of the first device includes: determining the N data processing modules based on data processing modules supported by the first device, available computational power of the first device, and the like.

According to the foregoing solution, the network device may send data processing module configuration information to the first device, so that the first device compresses the first data based on the data processing module configuration information.

With reference to the second aspect, in some implementations of the second aspect, the data processing modules are deployed at a physical layer.

Alternatively, the data processing modules may be deployed at an upper layer or an application layer of a protocol stack.

With reference to the second aspect, in some implementations of the second aspect, the method further includes: determining the first configuration information based on the first data, the task scenario, and/or the capability of the first device.

According to the foregoing solution, data processing modules to be used for compressing the first data are determined based on a data type of the first data, the task scenario, and/or the capability of the first device, thereby enabling more flexible configuration of the data processing modules and saving resources required for formulating the compression procedures while ensuring compression performance.

With reference to the second aspect, in some implementations of the second aspect, the method further includes: receiving capability information of the first device.

According to the foregoing solution, the network device obtains the capability information of the first device, and configures, based on the capability information, data processing module configurations for compressing different data.

With reference to the second aspect, in some implementations of the second aspect, the N data processing modules are data processing modules in a preconfigured data processing module pool, and the data processing module pool includes the N data processing modules.

Optionally, in addition to the N data processing modules, the data processing module pool further includes other data processing modules.

With reference to the second aspect, in some implementations of the second aspect, the data processing module pool further includes an index of each of the N data processing modules.

Optionally, the data processing module pool further includes indexes of other data processing modules in addition to the N data processing modules.

According to the foregoing solution, the data processing module pool includes a plurality of data processing modules and corresponding indexes, which facilitates configuration indication for compressing different types of data.

With reference to the second aspect, in some implementations of the second aspect, the data processing module pool includes M data processing module sets, the data processing module set includes at least one data processing module, the N data processing modules are data processing modules in the M data processing module sets, and data processing modules in each of the M data processing module sets perform a same data processing function.

According to the foregoing solution, the data processing modules in the data processing module pool are classified based on functions, which facilitates configuration of the data processing modules.

With reference to the second aspect, in some implementations of the second aspect, the method further includes: sending data processing module pool configuration information.

With reference to the second aspect, in some implementations of the second aspect, the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

According to the foregoing solution, the first configuration information includes data processing module configurations corresponding to data of a plurality of types, and the data processing modules may be flexibly configured as required based on requirements of data of different types.

With reference to the second aspect, in some implementations of the second aspect, the method further includes: sending second configuration information. The second configuration information is used to determine X data processing modules that compress third data, a third sequence, and/or a third compression parameter, the third sequence is a sequence of processing data by the X data processing modules, the third compression parameter is a parameter used by the X data processing modules to process data, and the third data and the first data are data of a same type or data of a same application. The X data processing modules are not completely the same as the N data processing modules, and/or the third sequence is not completely the same as the first sequence, and/or the first compression parameter is not completely the same as the third compression parameter.

With reference to the second aspect, in some implementations of the second aspect, the method further includes: determining the second configuration information based on the first data, the task scenario, and/or the capability of the first device.

According to the foregoing solution, when a condition such as the task scenario changes, the data processing module configuration for compressing the first data is updated, so that the data processing modules are flexibly configured based on a specific situation.

With reference to the second aspect, in some implementations of the second aspect, the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

According to the foregoing solution, the second configuration information includes data processing module configurations corresponding to data of a plurality of types, and the data processing modules may be flexibly configured as required based on requirements of data of different types.

With reference to the second aspect, in some implementations of the second aspect, determining the second configuration information based on the first data, the task scenario, and/or the capability of the first device includes: when a first condition is met, determining the second configuration information based on the first data, the task scenario, and/or the capability of the first device. The first condition includes one or more of the following conditions: an update-period condition, a task-scenario condition, a compression-quality condition of the first data, a mobility condition of the first device, and a user-request condition.

According to the foregoing solution, when the first condition is met, the network device may trigger to update the data processing module configuration, thereby ensuring validity of the data processing module configuration.

With reference to the second aspect, in some implementations of the second aspect, the method further includes: receiving first training data. The first training data includes training data corresponding to the first data.

With reference to the second aspect, in some implementations of the second aspect, the method further includes: sending first request information. The first request information is used to request to obtain the first training data.

According to a third aspect, a communication apparatus is provided. The apparatus may be a first device, or may be a module (for example, a chip or a circuit) of the first device.

The apparatus includes a processing module, configured to control the apparatus to compress first data by using N preconfigured data processing modules, where the compression corresponds to at least one data processing operation, a combination of functions of the N data processing modules includes the at least one data processing operation, the N data processing modules are determined based on the first data, a task scenario, and/or a capability of a first device, and N is a natural number greater than 0; and send the compressed first data.

In a possible implementation, the data processing modules are deployed at a physical layer.

Alternatively, the data processing modules may be deployed at an upper layer or an application layer of a protocol stack.

In a possible implementation, the processing module is further configured to control the apparatus to compress the first data by using the N data processing modules based on a first sequence and a first compression parameter. The first sequence is a sequence of processing data by the N data processing modules, and the first compression parameter is a parameter used by the N data processing modules to process data.

In a possible implementation, the first sequence and/or the first compression parameter is determined based on the first data, the task scenario, and/or the capability of the first device.

In a possible implementation, the N data processing modules are data processing modules in a preconfigured data processing module pool, and the data processing module pool includes the N data processing modules.

In a possible implementation, the data processing module pool further includes an index of each of the N data processing modules.

In a possible implementation, the data processing module pool includes M data processing module sets, the data processing module set includes at least one data processing module, the N data processing modules are data processing modules in the M data processing module sets, and data processing modules in each of the M data processing module sets perform a same data processing function.

In a possible implementation, the N data processing modules that compress the first data are determined from the data processing module pool based on the first data, the task scenario, and/or the capability of the first device.

In a possible implementation, the apparatus further includes a communication module, configured to receive or send first information. The first information is used to determine the data processing module pool.

In a possible implementation, that the communication module is further configured to receive or send the first information includes: receiving the first information, where the first information is data processing module pool configuration information or capability information of a second device.

Optionally, the communication module is configured to receive the first information sent by the network device or the second device.

In a possible implementation, the communication module is further configured to send the first information. The first information is data processing module pool configuration information or capability information of the first device.

Optionally, the communication module is further configured to send the first information to the network device or the second device.

Optionally, the second device and the network device are a same device.

In a possible implementation, the processing module is further configured to determine, based on first configuration information, the N data processing modules that compress the first data, the first sequence, and/or the first compression parameter. The first sequence is a sequence of processing data by the N data processing modules, and the first compression parameter is a parameter used by the N data processing modules to process data.

In a possible implementation, the communication module is further configured to receive or send the first configuration information.

Optionally, receiving the first configuration information includes: receiving the first configuration information sent by the network device or the second device.

Optionally, sending the first configuration information includes: sending the first configuration information to the network device or the second device.

Optionally, the second device and the network device are a same device.

In a possible implementation, the first configuration information includes indexes of N data processing modules corresponding to the first data, and the indexes of the N data processing modules are used to determine the N data processing modules and/or the first sequence.

In a possible implementation, the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

In a possible implementation, the processing module is further configured to determine, based on second configuration information, X data processing modules that compress third data, a third sequence, and/or a third compression parameter. The third sequence is a sequence of processing data by the X data processing modules, the third compression parameter is a parameter used by the X data processing modules to process data, and the third data and the first data are data of a same type or data of a same application. The X data processing modules are not completely the same as the N data processing modules, and/or the third sequence is not completely the same as the first sequence, and/or the first compression parameter is not completely the same as the third compression parameter.

In a possible implementation, the processing module is further configured to control the apparatus to compress the third data by using the X data processing modules.

In a possible implementation, the processing module is further configured to control the apparatus to compress the third data by using the X data processing modules based on the third sequence and the third compression parameter.

In a possible implementation, the communication module is further configured to receive or send the second configuration information.

Optionally, receiving the second configuration information includes: receiving the second configuration information sent by the network device or the second device.

Optionally, sending the second configuration information includes: sending the second configuration information to the network device or the second device.

Optionally, the second device and the network device are a same device.

In a possible implementation, the second configuration information includes indexes of the X data processing modules corresponding to the first data, and the indexes of the X data processing modules are used to determine the X data processing modules and/or the third sequence.

In a possible implementation, the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

In a possible implementation, the communication module is further configured to send first training data. The first training data includes training data corresponding to the first data.

In a possible implementation, the communication module is further configured to receive first request information. The first request information is used to request to obtain the first training data.

According to a fourth aspect, a communication apparatus is provided. The apparatus may be a second device or a network device, or may be a module (for example, a chip or a circuit) of the second device or the network device.

The apparatus includes a communication module, configured to send first configuration information. The first configuration information is used to determine N preconfigured data processing modules that compress first data, a first sequence, and/or a first compression parameter, the compression corresponds to at least one data processing operation, a combination of functions of the N data processing modules includes the at least one data processing operation, N is a natural number greater than 0, the first sequence is a sequence of processing data by the N data processing modules, the first compression parameter is a parameter used by the N data processing modules to process data, and the N data processing modules, the first sequence, and/or the first compression parameter are/is determined based on the first data, a task scenario, and/or a capability of a first device.

In a possible implementation, the data processing modules are deployed at a physical layer.

Alternatively, the data processing modules may be deployed at an upper layer or an application layer of a protocol stack.

In a possible implementation, the apparatus further includes a processing module, configured to determine the first configuration information based on the first data, the task scenario, and/or the capability of the first device.

In a possible implementation, the communication module is further configured to receive capability information of the first device.

In a possible implementation, the N data processing modules are data processing modules in a preconfigured data processing module pool, and the data processing module pool includes the N data processing modules.

In a possible implementation, the data processing module pool further includes an index of each of the N data processing modules.

In a possible implementation, the data processing module pool includes M data processing module sets, the data processing module set includes at least one data processing module, the N data processing modules are data processing modules in the M data processing module sets, and data processing modules in each of the M data processing module sets perform a same data processing function.

In a possible implementation, the communication module is further configured to send data processing module pool configuration information.

In a possible implementation, the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

In a possible implementation, the communication module is further configured to send second configuration information. The second configuration information is used to determine X data processing modules that compress third data, a third sequence, and/or a third compression parameter, the third sequence is a sequence of processing data by the X data processing modules, the third compression parameter is a parameter used by the X data processing modules to process data, and the third data and the first data are data of a same type or data of a same application. The X data processing modules are not completely the same as the N data processing modules, and/or the third sequence is not completely the same as the first sequence, and/or the first compression parameter is not completely the same as the third compression parameter.

In a possible implementation, the processing module is further configured to determine the second configuration information based on the first data, the task scenario, and/or the capability of the first device.

In a possible implementation, the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

In a possible implementation, the processing module is further configured to determine whether a first condition is met. When the first condition is met, the processing module controls the apparatus to determine the second configuration information based on the first data, the task scenario, and/or the capability of the first device. The first condition includes one or more of the following conditions: an update-period condition, a task-scenario condition, a compression-quality condition of the first data, a mobility condition of the first device, and a user-request condition.

In a possible implementation, the communication module is further configured to receive first training data. The first training data includes training data corresponding to the first data.

In a possible implementation, the communication module is further configured to send first request information, and the first request information is used to request to obtain the first training data.

According to a fifth aspect, a communication apparatus is provided, including a processor. The processor is coupled to a memory, and may be configured to perform the method in any possible implementation of the first aspect. In a possible implementation, the memory is included in the communication apparatus. In a possible implementation, the communication apparatus further includes a communication interface, and the processor is coupled to the communication interface.

In an implementation, the communication apparatus is a terminal device. When the communication apparatus is the terminal device, the communication interface may be a transceiver or an input/output interface. In a possible implementation, the transceiver may be a transceiver circuit. In a possible implementation, the input/output interface may be an input/output circuit.

In an implementation, the communication apparatus is a network device. When the communication apparatus is the network device, the communication interface may be a transceiver or an input/output interface. In a possible implementation, the transceiver may be a transceiver circuit. In a possible implementation, the input/output interface may be an input/output circuit.

In another implementation, the communication apparatus is a chip or a chip system. When the communication apparatus is the chip or the chip system, the communication interface may be an input/output interface, an interface circuit, an output circuit, an input circuit, a pin, a related circuit, or the like on the chip or the chip system. The processor may alternatively be embodied as a processing circuit or a logic circuit.

According to a sixth aspect, a communication apparatus is provided, including a processor. The processor is coupled to a memory, and may be configured to perform the method in any possible implementation of the second aspect. In a possible implementation, the memory is included in the communication apparatus. In a possible implementation, the communication apparatus further includes a communication interface, and the processor is coupled to the communication interface.

In an implementation, the communication apparatus is a network device. When the communication apparatus is the network device, the communication interface may be a transceiver or an input/output interface. In a possible implementation, the transceiver may be a transceiver circuit. In a possible implementation, the input/output interface may be an input/output circuit.

In another implementation, the communication apparatus is a chip or a chip system. When the communication apparatus is the chip or the chip system, the communication interface may be an input/output interface, an interface circuit, an output circuit, an input circuit, a pin, a related circuit, or the like on the chip or the chip system. The processor may alternatively be embodied as a processing circuit or a logic circuit.

According to a seventh aspect, a communication apparatus is provided, including an input circuit, an output circuit, and a processing circuit. The processing circuit is configured to: receive a signal through the input circuit, and transmit a signal through the output circuit, so that the method in either the first aspect or the second aspect and any one of the possible implementations of the foregoing aspects is implemented.

In a specific implementation process, the communication apparatus may be a chip, the input circuit may be an input pin, the output circuit may be an output pin, and the processing circuit may be a transistor, a gate circuit, a trigger, various logic circuits, or the like. An input signal received by the input circuit may be received and input by, for example, but not limited to, a receiver, and a signal output by the output circuit may be output to and transmitted by, for example, but not limited to, a transmitter. The input circuit and the output circuit may be different circuits or may be a same circuit, and in this case, the circuit is used as the input circuit and the output circuit respectively at different moments. Specific implementations of the processor and various circuits are not limited in embodiments of this application.

According to an eighth aspect, a processing apparatus is provided, including a processor and a memory. The processor is configured to: read instructions stored in the memory, receive a signal through a receiver, and transmit a signal through a transmitter, to perform the method in either the first aspect or the second aspect and any one of the possible implementations of the foregoing aspects.

In a possible implementation, there are one or more processors, and there are one or more memories.

In a possible implementation, the memory may be integrated with the processor, or the memory and the processor are disposed separately.

In a specific implementation process, the memory may be a non-transitory (non-transitory) memory, such as a read-only memory (read-only memory, ROM). The memory and the processor may be integrated into a same chip, or may be separately disposed in different chips. A type of the memory and a manner in which the memory and the processor are disposed are not limited in embodiments of this application.

It should be understood that a related data exchange process, such as sending indication information, may be a process in which the processor outputs indication information, and receiving capability information may be a process in which the processor receives input capability information. Specifically, data output by the processor may be delivered to a transmitter, and input data received by the processor may come from a receiver. The transmitter and the receiver may be collectively referred to as a transceiver.

The processor in the foregoing aspect may be a chip, and the processor may be implemented by using hardware or software. When the processor is implemented by using the hardware, the processor may be a logic circuit, an integrated circuit, or the like. When the processor is implemented by using the software, the processor may be a general-purpose processor, and is implemented by reading software code stored in the memory. The memory may be integrated into the processor, or may be located outside the processor and exist independently.

According to a ninth aspect, a computer program product is provided. The computer program product includes a computer program (which may also be referred to as code or instructions). When the computer program is run, a computer is enabled to perform the method in either the first aspect or the second aspect and any one of the possible implementations of the foregoing aspects.

According to a tenth aspect, a computer-readable storage medium is provided. The computer-readable storage medium stores a computer program (which may also be referred to as code or instructions). When the computer program is run on a computer, the computer is enabled to perform the method in either the first aspect or the second aspect and any one of the possible implementations of the foregoing aspects.

According to an eleventh aspect, a chip system is provided, including a memory and a processor. The memory is configured to store a computer program, and the processor is configured to invoke the computer program from the memory and run the computer program, to enable a communication device on which the chip system is installed to perform the method in either the first aspect or the second aspect and any one of the possible implementations of the foregoing aspects.

The chip system may include an input circuit or interface for sending information or data, and an output circuit or interface for receiving information or data.

According to a twelfth aspect, a communication system is provided, including the communication apparatus according to either the third aspect or the fourth aspect.

### BRIEF DESCRIPTION OF DRAWINGS

FIG. 1 is a diagram of an example of a communication system to which this application is applicable;
FIG. 2 is a diagram of a physical layer compression framework according to an embodiment of this application;
FIG. 3 is a diagram of a physical layer compression framework according to an embodiment of this application;
FIG. 4 is a schematic flowchart of a communication method according to an embodiment of this application;
FIG. 5 is a schematic flowchart of a communication method according to an embodiment of this application;
FIG. 6 is a diagram of a communication method according to an embodiment of this application;
FIG. 7 is a schematic flowchart of a communication method according to an embodiment of this application;
FIG. 8 is a schematic flowchart of a communication method according to an embodiment of this application;
FIG. 9 is a block diagram of a communication apparatus according to an embodiment of this application; and
FIG. 10 is a block diagram of a communication apparatus according to an embodiment of this application.

### DESCRIPTION OF EMBODIMENTS

The following describes technical solutions of this application with reference to accompanying drawings.

To facilitate understanding of the technical solutions in this application, related technologies in embodiments of this application are first described.

With growing diversity of wireless communication application scenarios, a large amount of native data (for example, 6G radio access network (radio access network, RAN) native data (native data) and local data (local traffic)) is generated during wireless communication, and the data also brings new requirements for transmission, for example:
(1) sensing data: such as 2D/3D imaging data, environment reconstruction data, point cloud data, and positioning/tracking data;
(2) artificial intelligence (artificial intelligence, AI) data: such as distributed AI model/gradient update data and feature information extracted from a neural network; and
(3) channel H/CSI data: such as channel state information fed back by a device in a multi-antenna system.

The data usually features a large data volume, high redundancy, temporal/frequency/spatial correlations, and the like. For example, the imaging data and radar detection data have high sparsity, and the positioning/tracking data, environment imaging/reconstruction data, AI training data, and the like that are obtained over continuous time exhibit high temporal correlations. These sparsity and correlation properties may be used to compress to-be-transmitted data, to reduce transmission overheads. In addition, depending on requirements of specific sensing or AI tasks, a degree of lossy compression and transmission is acceptable in many scenarios, that is, original data does not need to be restored with 100% fidelity.

Considering specific positions for compression of the foregoing 6G data, compression at a physical layer offers the following advantages compared with compression at an application layer:
(1) RAN native data originates from the physical layer and is used for communication, so performing compression at the physical layer (Physical Layer, PHY) is more straightforward.
(2) Data compressed and decompressed at the PHY can be directly used by the PHY, which can better assist communication and Net4AI/AI4Net.
(3) Compressing data directly at the PHY can reduce an end-to-end latency compared with transmitting the data to the application layer for compression and decompression and then sending the data back to the physical layer.

Different data exhibits different characteristics. Although compression based on data characteristics is superior in terms of compression performance, different compression processes are used for different data, resulting in high standardization costs. How to formulate a flexible and easy-to-standardize compression configuration process while ensuring compression performance is a problem to be resolved.

This application provides a data compression method for different types of data. To-be-transmitted data is compressed at a physical layer by using a data processing module. A used physical layer data processing module and parameter may be flexibly configured based on a data type, a task scenario, a user equipment (User Equipment, UE) capability, a network device capability, and the like, to ensure compression performance while reducing standardization costs.

The following describes the technical solutions in this application.

The technical solutions in embodiments of this application may be applied to various communication systems, for example, a long term evolution (long term evolution, LTE) system, an LTE frequency division duplex (frequency division duplex, FDD) system, LTE time division duplex (time division duplex, TDD), a universal mobile telecommunications system (universal mobile telecommunications system, UMTS), a worldwide interoperability for microwave access (worldwide interoperability for microwave access, WiMAX) communication system, a 5th generation (5th generation, 5G) system or new radio (new radio, NR) and a future communication system, and vehicle-to-X (vehicle-to-X, V2X), where V2X may include vehicle-to-network (vehicle-to-network, V2N), vehicle-to-vehicle (vehicle-to-vehicle, V2V), vehicle-to-infrastructure (vehicle-to-infrastructure, V2I), vehicle-to-pedestrian (vehicle-to-pedestrian, V2P), and the like, long term evolution-vehicle (long term evolution-vehicle, LTE-V), internet of vehicles, machine-type communication (machine-type communication, MTC), internet of things (internet of things, IoT), long term evolution-machine (long term evolution-machine, LTE-M), machine to machine (machine to machine, M2M), and the like.

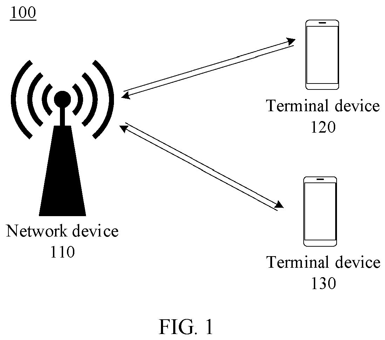

FIG. 1 is a diagram of a communication system according to an embodiment of this application. As shown in FIG. 1, the communication system 100 includes at least one network device, for example, a network device 110 shown in FIG. 1. The communication system 100 may further include at least one terminal device, for example, a terminal device 120 and/or a terminal device 130 shown in FIG. 1. The network device 110 may communicate with the terminal device 120/130 through a radio link, to exchange information. It may be understood that the network device and the terminal device may also be referred to as communication devices.

The network device is a network side device having a wireless transceiver function. The network device may be an apparatus that is in a radio access network (radio access network, RAN) and that provides a wireless communication function for the terminal device, and is referred to as a RAN device. For example, the network device may be a base station (base station), an evolved NodeB (evolved NodeB, eNodeB), a next generation NodeB (next generation NodeB, gNB) in a 5G mobile communication system, a subsequent evolved 3GPP base station, a transmission reception point (transmission reception point, TRP), an access node in a Wi-Fi system, a wireless relay node, a wireless backhaul node, or the like. In communication systems using different radio access technologies (radio access technologies, RATs), names of devices having base station functions may be different. For example, the base station may be referred to as an eNB or an eNodeB in an LTE system, and may be referred to as a gNB in a 5G system or an NR system. A specific name of the base station is not limited in this application. The network device may include one or more co-site or non-co-site transmission reception points. For another example, the network device may include at least one of the following: one or more central units (central units, CUs), one or more distributed units (distributed units, DUs), or one or more radio units (radio units, RUs). In different systems, the CU (or CU-CP and CU-UP), the DU, or the RU may alternatively have different names, but a person skilled in the art may understand meanings thereof. For example, the radio access network may also be of an open radio access network (open radio access network, O-RAN) architecture. In an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. Any unit of the CU (or the CU-CP or the CU-UP), the DU, and the RU in this application may be implemented by using a software module, a hardware module, or a combination of the software module and the hardware module. For example, functions of the CU may be implemented by one entity or different entities. For example, the functions of the CU are further divided. To be specific, a control plane and a user plane are separated and implemented by different entities, which are respectively a control plane CU entity (namely, a CU-CP entity) and a user plane CU entity (namely, a CU-UP entity). The CU-CP entity and the CU-UP entity may be coupled to the DU, to jointly complete a function of an access network device. For example, the CU is responsible for processing a non-real-time protocol and service, and implements functions of a radio resource control (radio resource control, RRC) layer and a packet data convergence protocol (packet data convergence protocol, PDCP) layer. The DU is responsible for processing a physical layer protocol and a real-time service, and implements functions of a radio link control (radio link control, RLC) layer, a media access control (media access control, MAC) layer, and a physical (physical, PHY) layer. In this way, some functions of a radio access network device may be implemented by a plurality of network function entities. These network function entities may be network elements in a hardware device, or may be software functions run on dedicated hardware, or may be virtualized functions instantiated on a platform (for example, a cloud platform). The network device may further include an active antenna unit (active antenna unit, AAU for short). The AAU implements some physical layer processing functions, radio frequency processing, and a function related to an active antenna. Information at the RRC layer is eventually converted into information at the PHY layer, or is converted from information at the PHY layer. Therefore, in this architecture, higher layer signaling such as RRC layer signaling may also be considered as being sent by the DU or sent by the DU and the AAU. It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application. For another example, in a vehicle to everything (vehicle to everything, V2X) technology, the access network device may be a road side unit (road side unit, RSU). A plurality of access network devices in the communication system may be base stations of a same type, or may be base stations of different types. The base station may communicate with the terminal device, or may communicate with the terminal device by using a relay station. In embodiments of this application, an apparatus configured to implement a function of the network device may be the network device, or may be an apparatus that can support the network device in implementing the function, for example, a chip system or a combined device or component that can implement the function of the access network device. The apparatus may be installed in the network device. In this embodiment of this application, the chip system may include a chip, or may include a chip and another discrete component.

The terminal device is a user side device having a wireless transceiver function, and may be a fixed device, a mobile device, a handheld device (for example, a mobile phone), a wearable device, a vehicle-mounted device, or a wireless apparatus (for example, a communication module, a modem, or a chip system) built in the foregoing device. The terminal device is configured to connect people, things, machines, and the like, and may be widely used in various scenarios, for example, cellular communication, device-to-device (device-to-device, D2D) communication, V2X communication, machine-to-machine/machine-type communication (machine-to-machine/machine-type communication, M2M/MTC) communication, internet of things, virtual reality (virtual reality, VR), augmented reality (augmented reality, AR), industrial control (industrial control), self driving (self driving), telemedicine (remote medical), a smart grid (smart grid), smart furniture, a smart office, a smart wearable, smart transportation, a smart city (smart city), an uncrewed aerial vehicle, and a robot. For example, the terminal device may be a handheld terminal in cellular communication, a communication device in D2D, an internet of things device in MTC, a surveillance camera in smart transportation and a smart city, or a communication device in an uncrewed aerial vehicle. The terminal device may be sometimes referred to as user equipment (user equipment, UE), a user terminal, a user apparatus, a subscriber unit, a subscriber station, a terminal, an access terminal, an access station, a UE station, a remote station, a mobile device, a wireless communication device, or the like. The terminal device may alternatively be a terminal device in an IoT system. IoT is an important part of future information technology development. A main technical feature of IoT is to connect things to a network by using a communication technology, to implement a smart network for human-machine interconnection and thing-thing interconnection. In this embodiment of this application, the IoT technology can implement massive connections, deep coverage, and terminal power saving by using, for example, a narrowband (narrowband, NB) technology. In embodiments of this application, an apparatus configured to implement a function of the terminal device may be the terminal device, or may be an apparatus that can support the terminal device in implementing the function, for example, a chip system or a combined device or component that can implement the function of the terminal device. The apparatus may be installed in the terminal device.

The network device and the terminal device may be deployed on land, including being deployed indoors or outdoors, or in a handheld manner or a vehicle-mounted manner; may be deployed on water; or may be deployed on an airplane, a balloon, and a satellite in the air. Scenarios in which the network device and the terminal device are located are not limited in embodiments of this application.

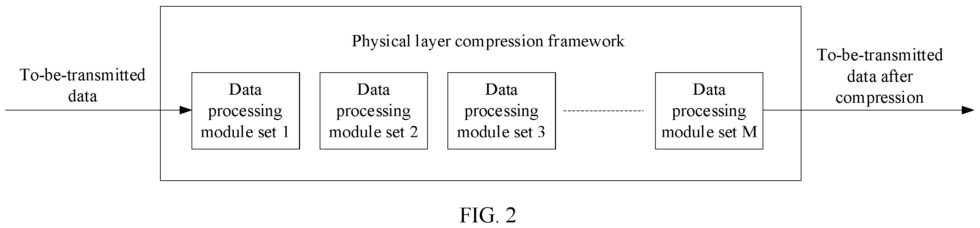

FIG. 2 is a diagram of a physical layer compression (source coding) framework according to this application. The physical layer compression framework is used to compress to-be-transmitted data. After the to-be-transmitted data is processed in the framework, other physical layer processing, such as channel coding (channel coding), modulation (modulation), resource mapping (resource mapping), and antenna mapping (antenna mapping), is performed.

As shown in FIG. 2, the physical layer compression framework includes M data processing module sets, the M data processing module sets jointly form one data processing module pool, and each data processing module set includes a plurality of basic data processing modules.

One or more data processing modules in the data processing module pool process to-be-transmitted data based on a specific processing sequence and a data processing parameter, to compress the to-be-transmitted data.

Each data processing module set corresponds to a major category of compression-related data processing functions, for example, data reorganizing (Data reorganizing), data filtering (Data filtering), data transform (Data transform), data selection (Data selection), quantization (Quantization), entropy coding (Entropy coding), and channel mapping (Channel mapping). In other words, data processing modules in each data processing module set are configured to perform a same data processing function, or data processing modules in each data processing module set are configured to perform a same category of data processing functions. For example, data processing modules in a data transform set are all configured to perform a data transform function, and data processing modules in an entropy coding set are all configured to perform an entropy coding function. Each data processing module in the data processing module set has a different execution manner. For example, the data processing modules in the data transform set include a differential processing module, a dictionary transform module, and the like. An execution manner of the differential processing module is to perform differential processing on data, and an execution manner of the dictionary transform module is to perform dictionary transform on data.

For example, when M=7, the data processing module pool includes seven data processing module sets. For example, the seven data processing module sets are respectively a data reorganizing set, a data filtering set, a data transform set, a data selection set, a quantization set, an entropy coding set, and a channel mapping set.

Table 1 shows an example of a data processing module pool configuration when M=7.

**Table 1**

| (1) Data reorganizing | (2) Data filtering | (3) Data transform | (4) Data selection | (5) Quantization | (6) Entropy coding | (7) Channel mapping |
|---|---|---|---|---|---|---|
| ·segmentation | ·tree-based data filtering | ·differential | ·based on threshold | ·fix quant. | ·Arithmetic coding | ·EEP |
| | | ·dictionary transform | | | | |
| | ·bitmap-based data filtering | ·SVD | | | | |
| ·reshape | | ·DFT/IDFT/DCT/IDC T | ·based on bitmap | ·non-uniform quant. | ·Huffman coding | |
| ·regrouping/clust ering | | | | ·dynamic quant. | | ·UEP |
| | ·semantic-based data filtering | ·low-rank approximation | ·based on resource | | ·Run length coding | ·... |
| | | | | ·vector quant. ·... | | |
| ·... | | | | | | |
| | | ·3D→2D projection | ·... | | ·... | |
| | ·... | ·... | | | | |

Data processing modules in each of the seven data processing module sets perform a same data processing function, such as a data reorganizing function and a data filtering function.

It should be understood that the data processing module pool may alternatively use another combination manner. To be specific, the data processing module pool is divided into different quantities of data processing module sets based on different classification manners of data processing functions. A classification manner and a quantity of data processing module sets are not limited in this application.

For example, the data processing modules may alternatively be represented by another data processing module set, for example, classified into five data processing module sets, that is, M=5. The re-classified data processing module pool may include five data processing module sets: data preprocessing (Preprocessing), data transform (Data transform), data quantization and selection (Data quantization & selection), entropy coding (Entropy coding), and channel mapping (Channel mapping).

Table 2 shows an example of a data processing module pool configuration when M=5. Data processing modules in each of the five data processing module sets perform a same data processing function, such as a data preprocessing function, a data quantization and selection function.

**Table 2**

| (1) Preprocessing | (2) Data transform | (3) Data quantization & selection | (4) Entropy coding | (5) Channel mapping |
|---|---|---|---|---|
| ·segmentation | ·differential | ·fix quant. | ·Arithmetic coding | ·EEP |
| ·reshape | ·dictionary transform | | | |
| ·regrouping/cluster ing | | ·non-uniform quant. | | |
| ·tree-based data filtering | ·SVD | ·dynamic quant. | ·Huffman coding | |
| | ·DFT/IDFT/DCT/I DCT | ·vector quant. | | |
| | | | | ·UEP |
| | | ·based on threshold | | |
| ·bitmap-based data filtering | ·low-rank approximation | ·based on bitmap | ·Run length coding | ·... |
| ·semantic-based data filtering | | ·based on resource | ·... | |
| | ·3D→2D projection | ·... | | |
| ·... | ·... | | | |

Table 3 shows an example of a data processing module pool configuration when M=4. Four data processing module sets are included: data preprocessing (Preprocessing), data transform (Data transform), data quantization and selection (Data quantization & selection), and channel mapping (Channel mapping). The data preprocessing set and the channel mapping set are optional data processing module sets.

**Table 3**

| (1) Preprocessing | (2) Data transform | (3) Data quantization & selection | (5) Channel mapping |
|---|---|---|---|
| ·segmentation | ·differential | ·fix quant. | ·EEP |
| ·reshape | ·dictionary transform | ·non-uniform quant. | |
| ·regrouping/clustering | ·SVD | ·dynamic quant. | |
| ·tree-based data filtering | ·DFT/IDFT/DCT/IDCT | ·vector quant. | |
| ·bitmap-based data filtering | ·low-rank approximation | ·based on threshold | ·UEP |
| | | | ·... |
| | | ·based on bitmap | |
| ·semantic-based data filtering | ·3D→2D projection | ·based on resource | |
| ·... | ·... | ·... | |

Table 4 shows an example of a data processing module pool configuration when M=3. Three data processing module sets are included: data preprocessing (Preprocessing), data transform (Data transform), and data quantization and selection (Data quantization & selection). The data preprocessing set is an optional data processing module set.

**Table 4**

| (1) Preprocessing | (2) Data transform | (3) Data quantization & selection |
|---|---|---|
| ·segmentation | ·differential | ·fix quant. |
| ·reshape | ·dictionary transform | ·non-uniform quant. |
| ·regrouping/clustering | ·SVD | ·dynamic quant. |
| ·tree-based data filtering | ·DFT/IDFT/DCT/IDCT | ·vector quant. |
| ·bitmap-based data filtering | ·low-rank approximation | ·based on threshold |
| | | ·based on bitmap |
| ·semantic-based data filtering | ·3D→2D projection | ·based on resource |
| ·... | ·... | ·... |

Table 5 shows another example of a data processing module pool configuration when M=3. Three data processing module sets are included: data transform (Data transform), data quantization and selection (Data quantization & selection), and channel mapping (Channel mapping). The channel mapping set is an optional data processing module set.

**Table 5**

| (2) Data transform | (3) Data quantization & selection | (5) Channel mapping |
|---|---|---|
| ·differential | ·fix quant. | ·EEP |
| | ·non-uniform quant. | |
| ·dictionary transform | ·dynamic quant. | |
| ·SVD | ·vector quant. | |
| ·DFT/IDFT/DCT/IDCT | ·based on threshold | ·UEP |
| ·low-rank approximation | ·based on bitmap | ·... |
| ·3D→2D projection | ·based on resource | |
| ·... | ·... | |

Table 6 shows another example of a data processing module pool configuration when M=2. Two data processing module sets are included: data transform (Data transform) and data quantization and selection (Data quantization & selection).

**Table 6**

| (2) Data transform | (3) Data quantization & selection |
|---|---|
| ·differential | ·fix quant. |
| ·dictionary transform | ·non-uniform quant. |
| ·SVD | ·dynamic quant. |
| ·DFT/IDFT/DCT/IDCT | ·vector quant. |
| ·low-rank approximation | ·based on threshold |
| ·3D→2D projection | ·based on bitmap |
| ·... | ·based on resource |
| | ·... |

It should be understood that, when a value of M varies, the data processing module pool includes different data processing module sets. When values of M are the same, data processing module sets included in the data processing module pool may be the same or may be different, and data processing modules included in data processing module sets with a same name may be the same or may be different.

The following uses Table 1 as an example to specifically describe data processing modules included in the seven data processing module sets.
(1) The data reorganizing set includes data processing modules such as data segmentation (segmentation), data reshape (reshape), and data regrouping/clustering (regrouping/clustering).

It should be understood that a name of a data processing module may also be understood as a data processing function performed by the data processing module.

Data segmentation: Given data is split based on a specified segmentation parameter. The given data may be a one-dimensional vector (with a length of L), a two-dimensional matrix (with a size of L₁*L₂), and the like. The one-dimensional vector and the two-dimensional matrix are described as follows:

One-dimensional vector: As shown in Table 7, the segmentation parameter is P={P₁, P₂, P₃, ...}, and P₁, P₂, P₃, ... respectively represent segmentation positions of the one-dimensional vector. For example, data numbered from 1 to P₁ is a first segment, data numbered from P₁+1 to P₂ is a second segment, and data numbered from P₂+1 to P₃ is a third segment.

**Table 7**

| | | | | | | | | | | |
|---|---|---|---|---|---|---|---|---|---|---|
| 1 | ... | P₁ | P₁+1 | ... | P₂ | P₂+1 | ... | P₃ | ... | L |

Two-dimensional matrix: As shown in Table 8, the segmentation parameters are P₁={P_{1,1}, P_{1,2}, P_{1,3}, ...} and P₂={P_{2,1}, P_{2,2}, P_{2,3}, ... }, respectively corresponding to segmentation positions of two dimensions. For example, data numbered from [1, 1] to [P_{1,1}, P_{2,1}] is a first segment, and data numbered from [1, P_{2,1}+1] to [P_{1,1}, P_{2,1}+1] is a second segment.

**Table 8**

| | | | | | | | |
|---|---|---|---|---|---|---|---|
| [1, 1] | ... | [1, P_{2,1}] | [1, P_{2,1}+1] | ... | [1, P_{2,2}] | ... | [1, L₂] |
| ... | ... | ... | ... | ... | ... | ... | ... |
| [P_{1,1}, 1] | ... | [P_{1,1}, P_{2,1}] | [P₁,₁, P_{2,1}+1] | ... | [P_{1,1}, P_{2,2}] | ... | ... |
| [P_{1,1}+1, 1] | ... | [P_{1,1}+1, P_{2,1}] | [P_{1,1}+1, P_{2,1}+1] | ... | [P_{1,1}+1, P_{2,2}] | ... | ... |
| ... | ... | ... | ... | ... | ... | ... | ... |
| [P_{1,2}, 1] | ... | [P_{1,2}, P_{2,1}] | [P_{1,2}, P_{2,1}+1] | ... | [P_{1,2}, P_{2,2}] | ... | ... |
| ... | ... | ... | ... | ... | ... | ... | ... |
| [L₁, 1] | ... | ... | ... | ... | ... | ... | [L₁, L₂] |

Data reshape: Data of a given size of L₁×L₂×...×L_{N} is processed and reshaped to data of a size of L'₁×L'₂×...×L'_{M}, where L₁×L₂×...×L_{N}=L'₁×L'₂×...×L'_{M} is satisfied, and the two sets of data include same elements.

Data regrouping/clustering: Grouping is performed based on a data type (for example, different types of sensing/imaging data or neural network data) or based on data distribution (for example, different source distributions such as a 0/1 ratio), to obtain different groups or categories.

(2) The data filtering set includes data processing modules such as tree-based data filtering (tree-based data filtering), bitmap-based data filtering (bitmap-based data filtering), and semantic-based data filtering (semantic-based data filtering).

Tree-based data filtering: A tree structure corresponding to data is defined. For example, two-dimensional data corresponds to a quadtree, and three-dimensional data corresponds to an octree. Data filtering is indicated by specifying whether different leaf nodes in the tree structure are filtered out or retained.

Bitmap-based data filtering: A bitmap (bitmap) corresponding to data or data blocks is defined, and a value of an element in the bitmap is 0 or 1, respectively indicating whether a corresponding data element or data block is filtered out or retained.

Semantic-based data filtering: Semantics related to data content is defined, and whether to filter out or retain data is indicated or determined based on the semantics (for example, only data that matches the semantics is retained, while non-matching data is filtered out).

(3) The data transform set includes data processing modules such as differential processing (differential), dictionary transform (dictionary transform), singular value decomposition (Singular Value Decomposition, SVD), discrete Fourier transform/inverse discrete Fourier transform/discrete cosine transform/inverse discrete cosine transform (Discrete Fourier Transform/Inverse Discrete Fourier Transform/Discrete Cosine Transform/Inverse Discrete Cosine Transform, DFT/IDFT/DCT/IDCT), low-rank approximation (low-rank approximation), and three-dimensional to two-dimensional projection (3D→2D projection).

Differential processing: Differential operations (for example, direct differencing or weighted differencing) are performed on data across different dimensions such as time, space, and frequency, to remove redundant information by using temporal, spatial, and frequency correlations.

Dictionary transform: Data **X** is transformed based on a configured dictionary **D** to obtain a transformed result **Y**=**DX**, so that a difference between **D**⁻¹**Y** and **X** is minimized. For example, the difference is measured by using a 1-norm, a Euclidean distance, or the like. **D** may be obtained through offline or online data training, or may be preset in advance in a protocol, and **Y** has a smaller information amount than original data X, which facilitates subsequent compression operations.

Singular value decomposition: Data X is represented in a form of **UΣV**^{*} (* represents a matrix conjugate transpose operation), where both **U** and **V** are unitary matrices and satisfy an orthogonal condition, and **Σ** is a non-negative real diagonal matrix.

Discrete Fourier transform/inverse discrete Fourier transform/discrete cosine transform/inverse discrete cosine transform: DFT and DCT respectively use a Fourier operator and a cosine operator to transform data, while corresponding IDFT and IDCT correspond inverse transforms. Corresponding formulas are as follows:

### DFT/IDFT:

$\left\{\begin{matrix}X \left[k\right] = {\sum }_{n = 0}^{N - 1} x \left[n\right] {e}^{- j \frac{2 πkn}{N}} , k = 0 , 1 , 2 , … , N - 1 \\ x \left[n\right] = \frac{1}{N} {\sum }_{k = 0}^{N - 1} X \left[k\right] {e}^{j \frac{2 πkn}{N}} , n = 0 , 1 , 2 , … , N - 1\end{matrix}\right.$

DCT/IDCT: There are a plurality of types of DCT/IDCT. Herein, a type-II DCT/IDCT is as an example, as shown below: $\left\{\begin{matrix}X \left[k\right] = {\sum }_{n = 0}^{N - 1} x \left[n\right] cos \left(\frac{π}{N}k\left(n+\frac{1}{2}\right)\right) , k = 0 , 1 , 2 , … , N - 1 \\ x \left[n\right] = \frac{1}{N} X \left[0\right] + \frac{2}{N} {\sum }_{k = 1}^{N - 1} X \left[k\right] cos \left(\frac{π}{N}k\left(n+\frac{1}{2}\right)\right) , n = 0 , 1 , 2 , … , N - 1\end{matrix}\right.$

Low-rank approximation: A data matrix **X** is represented as a matrix **Y** whose matrix rank is lower than a preset threshold m, so that a difference between **X** and **Y** is minimized. For example, the difference is depicted by using a 1-norm, a Euclidean distance, or the like.

Three-dimensional to two-dimensional projection: A three-dimensional data signal is projected onto a specific two-dimensional plane according to a preset or online optimized rule, to reduce data redundancy. These rules may be to-be-projected plane coordinates, for example, represented by using a plane origin **O** and a normal vector **n,** or represented by using a function equation ax+by+cz=d corresponding to the plane; or 3D coordinates may be transformed into a 2D matrix/picture through polar coordinate or spherical coordinate transform.

(4) The data selection set includes data processing modules such as threshold-based data selection (based on threshold), bitmap-based data selection (based on bitmap), and resource-based data selection (based on resource).

Threshold-based data selection: K pieces of data and a threshold T are given, and a quantity P of numbers are selected from the data, where values of these numbers are less than (or greater than) T.

Bitmap-based data selection: A bitmap (bitmap) corresponding to data or data blocks is defined, and a value of an element in the bitmap is 0 or 1. For example, when a value of a bitmap element is 1, a corresponding data element or data block is selected, and when a value of a bitmap element is 0, a corresponding data element or data block is not selected.

Resource-based data selection: First, transmission is determined based on a configured or predefined quantity of transmission resources. When the quantity of transmission resources exceeds a quantity of original data, all data may be completely transmitted. When the quantity of original data exceeds the quantity of transmission resources, the original data needs to be first sorted by importance, and a most important portion of the original data is selected for transmission.

(5) The quantization set includes data processing modules such as fixed quantization (fix quantization), non-uniform quantization (non-uniform quantization), dynamic quantization (dynamic quantization), and vector quantization (vector quantization).

Fixed quantization: Data is quantized based on a configured or preset quantization parameter.

Non-uniform quantization: Data is quantized according to a non-uniform quantization table. The quantization table may be obtained through offline or online optimization according to statistical distribution of the data.

Dynamic quantization: Based on real-time probability distribution of current data, an optimal quantization range and quantization bits are dynamically selected to quantize the data.

Vector quantization: Data is represented as a form of a plurality of vectors, and a vector quantization table is used to perform a quantization operation on each vector (a vector in the vector quantization table is used to replace a vector in original data).

(6) The entropy coding set includes data processing modules such as arithmetic coding (Arithmetic coding), Huffman coding (Huffman coding), and run-length coding (Run length coding).

(7) The channel mapping set includes data processing modules such as equal error protection (equal error protection, EEP) and unequal error protection (unequal error protection, UEP).

Equal error protection: After data is represented as a bit stream, a same channel coding rate and modulation order are used for channel coding and modulation.

Unequal error protection: Original data is split or grouped into N groups of bit streams X₁, X₂, ..., and X_{N}. These bit streams have different importance or contribution to the original data. For different groups or layers, different modulation and coding schemes (Modulation and Coding Scheme, MCS) are used to perform channel coding and modulation processing to implement differentiated channel protection. If importance of X₁, X₂, ..., and X_{N} decreases in sequence, a lower channel coding rate and a lower modulation order are used for X₁, X₂, and the like, to provide higher transmission robustness, while a higher channel coding rate and a higher modulation order are used for X_{N}, X_{N-1}, and the like, to save transmission resources.

The following uses Table 3 as an example. The data processing module pool shown in Table 3 includes four data processing module sets: data preprocessing (Preprocessing), data transform (Data transform), data quantization and selection (Data quantization & selection), and channel mapping (Channel mapping).

Optionally, the data preprocessing set may include all or some data processing modules in the data reorganizing set and the data filtering set in Table 1.

Optionally, the data preprocessing set may include a data reorganizing data processing module and a data filtering data processing module. In this case, data reorganizing and data filtering function as data processing modules instead of data processing module sets.

Optionally, the data transform set may include all or some data processing modules in the data transform set in Table 1.

Optionally, the data quantization and selection set may include all or some data processing modules in the data selection set and the quantization set in Table 1.

Optionally, the channel mapping set may include all or some data processing modules in the channel mapping set in Table 1.

Optionally, the channel mapping set may include data processing modules such as one-shot transmission (One-shot TX), incremental transmission (Incremental TX), equal error protection EEP, and unequal error protection UEP.

One-shot transmission indicates that data is transmitted in its entirety at a time, while incremental transmission indicates that a portion of data may be transmitted (for example, when transmission resources are limited), and a remaining portion may be transmitted subsequently (for example, when new transmission resources are available, or more data supplementation is required based on a task).

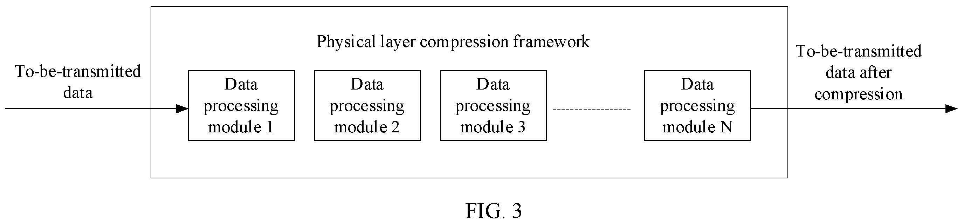

FIG. 3 is a diagram of another physical layer compression framework according to this application.

As shown in FIG. 3, the physical layer compression framework includes N data processing modules, and the N data processing modules jointly form one data processing module pool.

It should be understood that the physical layer compression framework shown in FIG. 3 does not divide the data processing modules into a plurality of data processing module sets. That is, FIG. 3 corresponds to a case in which M=1 in the physical layer compression framework shown in FIG. 2.

For descriptions of the data processing modules, refer to the descriptions of the physical layer compression framework in FIG. 2.

It should be understood that the data processing modules and the data processing module pool described above are data processing modules and a data processing module pool of a first device at a physical layer. The first device may be a network device, or may be a terminal device, or may be a module (for example, a chip or a circuit) in the network device or the terminal device.

The first device compresses to-be-transmitted data by using a data processing module at the physical layer, and sends the to-be-transmitted data to another device, for example, a second device. The second device may be a network device, or may be a terminal device, or may be a module (for example, a chip or a circuit) in the network device or the terminal device.

Compressing the to-be-transmitted data by the first device may be understood as compressing the to-be-transmitted data by using a plurality of data processing modules of the first device. The compression corresponds to at least one data processing operation, and a combination of functions of the plurality of data processing modules includes the at least one data processing operation.

For example, the compression includes three data processing operations: dictionary transform, non-uniform quantization, and bitmap-based data selection. Optionally, the plurality of data processing modules may be a dictionary transform module, a non-uniform quantization module, and a bitmap-based data selection module.

For example, the compression includes two data processing operations: data transform and data quantization and selection. In this case, a combination of functions of the plurality of data processing modules (for example, N data processing modules) includes data transform and data quantization and selection.

For example, the plurality of data processing modules may be a differential processing module in the data transform set, a fixed quantization module in the quantization set, and a resource-based data selection module in the data selection set.

For another example, the plurality of data processing modules may be a dictionary transform module in the data transform set, a non-uniform quantization module in the data quantization and selection set, and a bitmap-based data selection module.

The data processing module pool at the physical layer may be predefined, or may be configured by the network device or the second device and sent to the first device, or may be configured by the first device. The second device and the network device may be a same network device, or may be different devices.

The following describes in detail a data processing module pool configuration manner.

In a possible implementation, the data processing module pool is predefined or preconfigured. For example, the data processing module pool may be stipulated in a protocol (written into the specification).

In another possible implementation, the data processing module pool is configured by the network device or the second device.

Optionally, in a scenario in which the first device communicates with the network device, the data processing module pool of the first device is configured by the network device, and compressed data is sent to the network device.

Optionally, in a scenario in which the first device communicates with the second device, the data processing module pool of the first device is configured by the network device or the second device, and compressed data is sent to the second device.

For example, the network device or the second device configures the data processing module pool, and sends a data processing module pool configuration (Compress Module Pool Config.) to the first device in a broadcast/multicast/unicast-based manner. For example, the network device sends the data processing module pool configuration to the first device through radio resource control (Radio Resource Control, RRC)/media access control (Media Access Control, MAC) signaling.

The data processing module pool configuration manner is described below by using an example in which the network device performs the configuration.

For example, the network device may configure the data processing module pool for the first device based on a request of the first device and/or a capability of the first device. For example, the first device sends capability information (that is, one example of first information) of the first device to the network device, and the network device may determine the data processing module pool based on the capability information of the first device.

For example, the network device may send data processing module pool configuration information (that is, one example of the first information) to the first device, and the first device may determine the data processing module pool based on the data processing module pool configuration information.

In still another possible implementation, the data processing module pool is configured by the first device.

For example, the first device configures the data processing module pool, and reports the data processing module pool configuration to the second device and/or the network device.

For example, the first device may send the data processing module pool configuration information (that is, one example of the first information) to the second device and/or the network device, and the second device and/or the network device may determine the data processing module pool based on the data processing module pool configuration information.

For example, the first device receives capability information (that is, one example of the first information) of the second device sent by the network device or the second device, and the first device may determine the data processing module pool based on the capability information of the second device.

The following describes several specific formats of the data processing module pool configuration (Compress Module Pool Config.) It should be understood that various formats may be used for the data processing module pool configuration, and the data processing module pool configuration can indicate a supported data processing module. A specific format of the data processing module pool configuration is not limited in this application, and the following is merely an example.

For example, the data processing module pool configuration is shown in Table 9. The data processing module pool configuration includes a plurality of data processing module sets and data processing modules included in each data processing module set.

**Table 9**

| |
|---|
| ``` Compress Module Pool Config. { Data reorganizing {Segmentation, Reshape, Clustering}, Data filtering {Tree-based data filtering, Bitmap-based data filtering}, ... Channel mapping {UEP, EEP} ``` |

For example, the data processing module pool configuration is shown in Table 10. The data processing module pool configuration includes a plurality of data processing modules. It should be understood that the data processing module pool configuration does not include an indication of the data processing module set. The configuration is applicable to a scenario in which both the network device and the first device (or the second device and the first device) already know the data processing module set to which each basic data processing module belongs, or to a scenario in which it is unnecessary to explicitly indicate the data processing module set.

**Table 10**

| |
|---|
| ``` Compress Module Pool Config. { Segmentation, Reshape, Clustering, Tree-based data filtering, Bitmap-based data filtering, ... UEP, EEP ``` |

Optionally, the data processing module pool configuration may further indicate a compression parameter corresponding to each data processing module.

Optionally, the data processing module pool configuration further includes or indicates an index of each data processing module. The index may be an explicit or implicit index (for example, an index defined according to a sequence in which the data processing modules appear).

For example, in the data processing module pool configuration shown in Table 11, an index of the data processing module Segmentation is 1, an index of the data processing module Reshape is 2, and an index of the data processing module Clustering is 3.

**Table 11**

| (1) Data reorganizing | (2) Data filtering | (3) Data transform | (4) Data selection | (5) Quantization | (6) Channel mapping |
|---|---|---|---|---|---|
| 1. segmentation | 4. tree-based data filtering | 6. dictionary transform | 10. based on threshold | 13. fix quant. | 16. UEP |
| | | 7. SVD | 11. based on bitmap | 14. non-uniform quant. | |
| 2. reshape | 5. bitmap-based data filtering | 8. DFT | | | 17. EEP |
| 3. clustering | | 9. 3D-2D projection | 12. based on resource | 15. dynamic quant. | ... |
| ... | | | | | |
| | ... | ... | ... | ... | |

The first device may compress the to-be-transmitted data by using the data processing modules in the foregoing data processing module pool. For example, the to-be-transmitted data may be compressed by using N data processing modules.

Optionally, the N data processing modules, a first sequence, and/or a first compression parameter may be determined based on a data type of the to-be-transmitted data, a task scenario, and/or a capability of the first device, and the N data processing modules compress the to-be-transmitted data (that is, one example of first data) based on the first sequence and the first compression parameter.

For example, it is assumed that the data processing module pool of the first device is the data processing module pool shown in Table 1. When to-be-transmitted data of different types is sensing data, a data processing module configuration shown in Table 12 may be used to compress the to-be-transmitted data. Herein, (1), (2), (3), and the like represent a corresponding data processing module set.

**Table 12**

| | | |
|---|---|---|
| 1 | Sensing data: data processing module combination manner 1 | (1) Segmentation → (3) Dict. transform → (4) Data sel. based on thred. → (5) Fix quant. → (6) EEP |
| 2 | Sensing data: data processing module combination manner 2 | (1) Segmentation → (3) Dict. transform → (4) Data sel. based on bitmap → (3) Differential → (5) Fix quant. → (6) UEP |
| 3 | Sensing data: data processing module combination manner 3 | (2) Tree-based data filtering → (3) 3D→2D projection → (5) Fix quant. → (4) Data sel. based on thred. → (6) EEP |
| 4 | AI data: data processing module combination manner 1 | (1) Clustering → (3) Dict. transform → (4) Data sel. based on thred. → (5) Dynamic quant. → (6) UEP |
| 5 | H data: data processing module combination manner 1 | (3) SVD → (3) Dict. transform → (5) Fix quant. → (4) Data sel. based on res. → (6) EEP |
| 6 | H data: data processing module combination manner 2 | (1) Segmentation → (2) Bitmap-based data filtering → (3) DFT → (5) Fix quant. → (4) Data sel. based on res. → (6) EEP |

As shown in Table 12, for a same data type, data may be compressed by using different data processing module combinations. For example, for the sensing data, Table 12 shows three different data processing module combinations (rows 1, 2, and 3), and all of the three combinations can compress the data.

For example, for the sensing data, a data processing module combination in a 1^{st} row of Table 12 indicates that, for an input X of the sensing data, six compression steps are performed, namely data segmentation (Segmentation), dictionary transform (Dict. Transform), threshold-based data selection (Data sel. based on thred.), fixed quantization (Fix quant.), and equal error protection EEP. Each step corresponds to one basic data processing module. Herein, the data segmentation (Segmentation) belongs to the data reorganizing set (1), the dictionary transform (Dict. Transform) belongs to the data transform set (3), the threshold-based data selection (Data sel. based on thred.) belongs to the data selection set (4), the fixed quantization (Fix quant.) belongs to the quantization set (5), and the equal error protection EEP belongs to the channel mapping set (6).

For another example, for the sensing data, a 2^{nd} row of Table 12 provides another data processing module combination, indicating that, for an input X of the sensing data, six compression steps are performed, respectively segmentation (Segmentation), dictionary transform (Dict. Transform), bitmap-based data selection (Data sel. based on bitmap), differential coding (Differential), fixed quantization (Fix quant.), and unequal error protection UEP.

Similarly, for other types of data, such as AI data, different data processing module combinations may also be provided (rows 5 and 6 of Table 12).

In addition, the basic data processing modules described above may have different sequences in different data processing module combinations. For example, in compression combinations shown in rows 1 and 2, positions of (4) threshold-based data selection (Data sel. based on thred.) and (5) fixed quantization (Fix quant.) are swapped.

In a data processing module combination, a same data processing module set may alternatively appear a plurality of times. For example, in row 2 of the foregoing table, both the dictionary transform (Dict. Transform) and the differential coding (Differential) belong to the data transform set (3). For another example, in row 5 of the foregoing table, SVD and the dictionary transform (Dict. Transform) also belong to the data transform set (3). In both examples, the data transform set (3) appears twice in a data processing module combination.

The following describes in detail a data processing module configuration manner.

In a possible implementation, the data processing modules are configured by the network device or the second device.

The data processing module configuration manner is described below by using an example in which the network device performs the configuration.

For example, the network device configures the data processing modules, and sends a data processing module configuration (Compress Module Config.) to the first device in a broadcast/multicast/unicast-based manner. For example, the network device sends the data processing module configuration to the first device through RRC/MAC signaling.

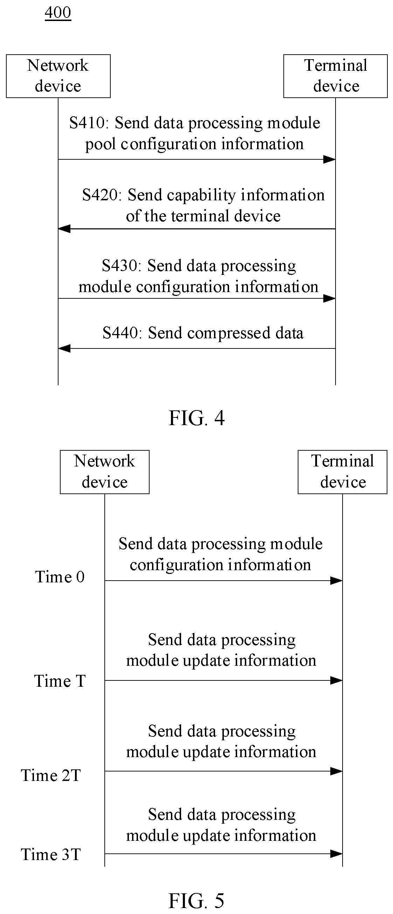

The method 400 shown in FIG. 4 includes the following steps.

S410 (optional step): The network device or the second device sends data processing module pool configuration information to the first device.

Before the data processing modules are configured for the first device, a data processing module pool may be first configured for the first device. For the data processing module pool configuration, refer to the foregoing descriptions.

S420 (optional step): The first device sends capability information of the first device to the network device.

Optionally, a capability of the first device includes data processing modules supported by the first device, available computational power of the first device, and the like.

Optionally, based on the capability of the first device, the network device may determine which data processing modules can be included in the data processing module configuration to be sent to the first device.

For example, Table 13 shows a manner of representing the capability of the first device.

Herein, "Data reorganizing: Clustering" indicates that the first device supports only clustering (Clustering) for data reorganizing (Data reorganizing), and "Data transform: 3D→2D projection, Dict. Transform" indicates that UE supports only three-dimensional to two-dimensional projection (3D→2D projection) and dictionary transform (Dict. Transform) for data transform (Data transform).

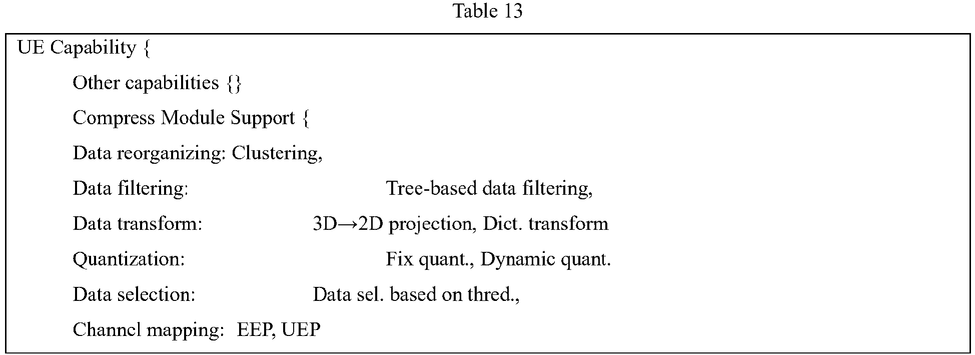

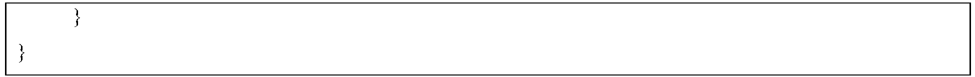

For example, Table 14 shows a manner of representing the capability of the first device. If the first device is configured with a data processing module pool, for example, the data processing module pool shown in Table 11, the capability of the first device may also reference a module index in the data processing module pool to indicate a supported data processing module.

**Table 14**

| |
|---|
| ``` UE Capability { Other capabilities {} Compress Module Support {3, 4, 6, 9, 10, 13, 15, 16, 17} ``` |

Optionally, the capability information of the first device may further indicate a limitation on a sequence of the data processing modules.

For example, as shown in Table 15, the capability information of the first device further indicates that a reorganizing module is required to run before a transform module.

**Table 15**

| |
|---|
| ``` UE Capability { Compress Module Support {...} Compress Module Order {Reorganizing before Transform} ``` |

For example, as shown in Table 16, if the first device is configured with a data processing module pool, for example, the data processing module pool shown in Table 11, the capability of the first device may also reference a module index in the data processing module pool, that is, a module whose index is 3 is required to run before a module whose index is 6.

**Table 16**

| |
|---|
| ``` UE Capability { Compress Module Support {...} Compress Module Order {3 before 6} ``` |

S430: The network device sends data processing module configuration information (that is, one example of first configuration information) to the first device.

The network device may configure a data processing module for the first device based on a request of the first device and/or the capability of the first device.

The following describes several specific formats of the data processing module configuration (Compress Module Config.) information. It should be understood that various formats may be used for the data processing module configuration information, and the data processing module configuration information indicates a manner of compressing the to-be-transmitted data by using the data processing module. A specific format of the data processing module configuration information is not limited in this application, and the following is merely an example.

For example, the data processing module configuration shown in Table 17 includes a data processing module combination for sensing data (Sensing Config {...}), and a data processing module combination for channel H data (H Config {...}).

Herein, "Data reorganizing: Segmentation" indicates that a data segmentation (Segmentation) data processing module in the data reorganizing (Data reorganizing) set is selected, and "Data transform: Dict. Transform" indicates that a dictionary transform (Dict. Transform) data processing module in the data transform (Data transform) set is selected, and so on. The data processing module combination (Sensing Config {...}) corresponds to row 1 in Table 12, and indicates that six compression steps are performed for an input X (that is, one example of the first data) of the sensing data, respectively data segmentation (Segmentation), dictionary transform (Dict. Transform), threshold-based data selection (Data sel. based on thred.), fixed quantization (Fix quant.), and equal error protection EEP. Each step corresponds to one basic data processing module. The data processing module combination (H Config {...}) corresponds to row 6 in Table 12, and represents a processing method for a channel data input.

In other words, the data processing module configuration information shown in Table 17 is further used to determine L data processing modules that compress channel data (that is, one example of the second data), a second sequence, and/or a second compression parameter.

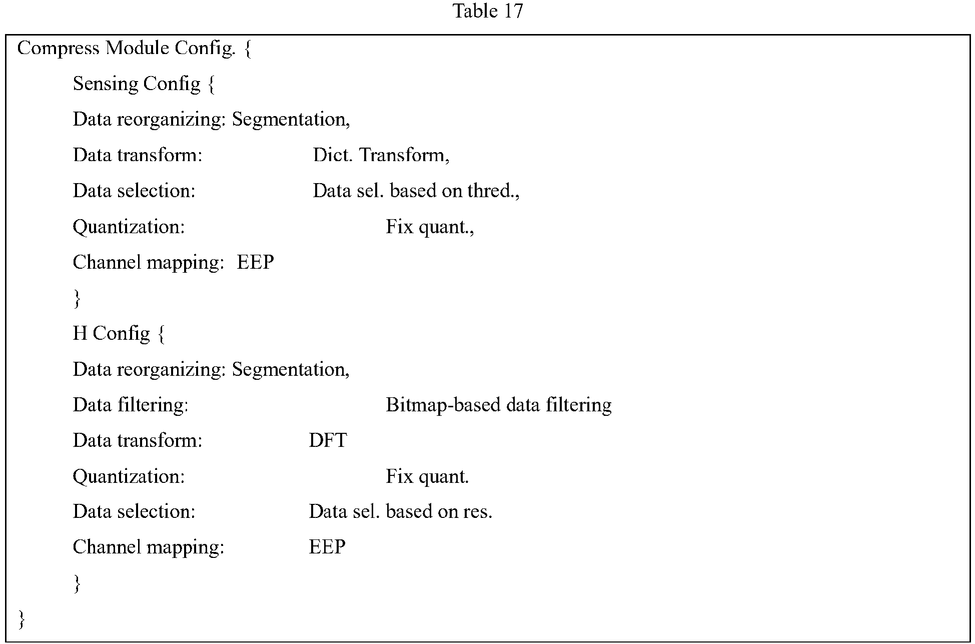

Data processing module combinations for the sensing data and channel H data are included in the data processing module configuration.

Optionally, a configuration of a corresponding data type may also include the data processing module configuration.

For example, in the data processing module configuration shown in Table 18, a related configuration (Sensing Config {...}) for the sensing data includes a data processing module configuration (Compress Module Config. {...}) corresponding to the sensing data, and a related configuration (H Config {...}) for the H data includes a data processing module configuration (Compress Module Config. {...}) corresponding to the H data.

It should be understood that Table 18 is another representation manner of Table 17. A representation manner of the data processing module configuration is not limited in this application.

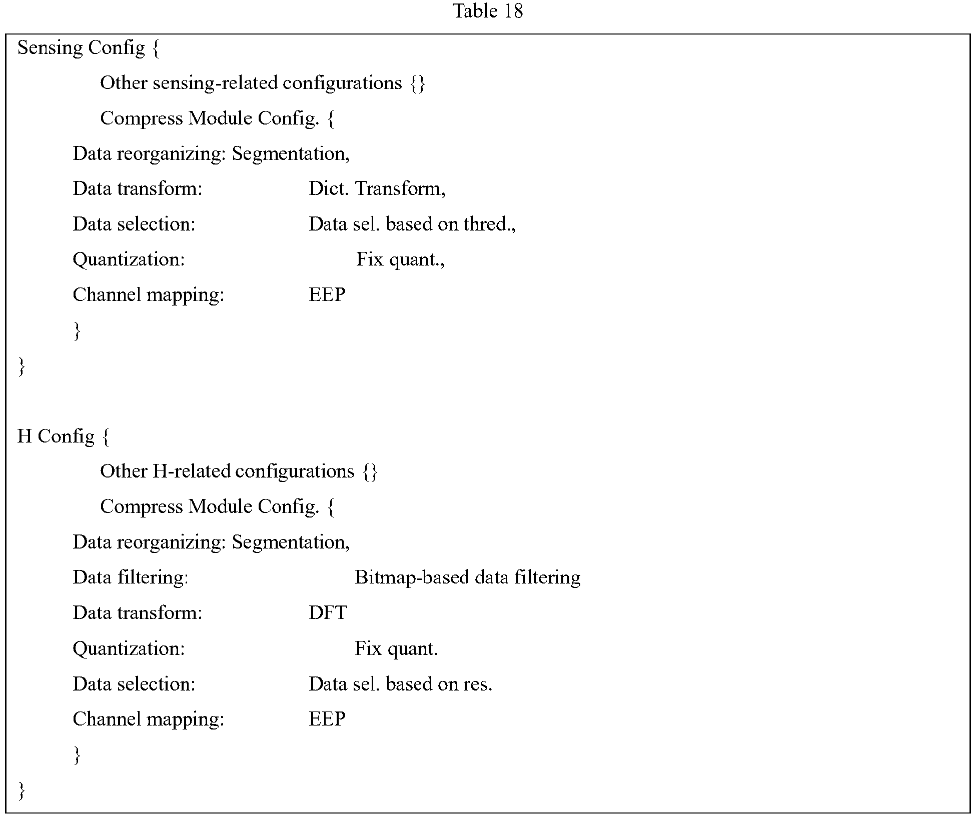

For example, in the data processing module configuration shown in Table 19, if both the network device and the first device already know the data processing module set to which each basic data processing module belongs (for example, as defined by a protocol), or if it is unnecessary to explicitly indicate the data processing module set (there is no data processing module set, or there is only one data processing module set, namely, the data processing module pool), the data processing module set may not be specified in the data processing module configuration.

It should be understood that Table 19 is another representation manner of Table 17. A representation manner of the data processing module configuration is not limited in this application.

**Table 19**

| |
|---|
| ``` Compress Module Config. { ``` |
| ``` Sensing Config { Segmentation, Dict. Transform, Data sel. based on thred., Fix quant., EEP } H Config { Segmentation, Bitmap-based data filtering DFT Fix quant. Data sel. based on res. EEP } ``` |

Optionally, the data processing module configuration may further include compression parameters corresponding to the data processing modules. For example, in Sensing Config {...} of Table 17, the configuration may further include a data segmentation parameter corresponding to "Data reorganizing: Segmentation", for example, P={P₁, P₂, P₃, ...}, and may further include a transformation dictionary D corresponding to "Data transform:
Dict. Transform", and so on. In addition, the data processing module configuration may further indicate input and output dimension information of each data processing module, for example, indicate that an input data dimension/size of "Data sel. based on res." is M1 and an output (after selection) data dimension/size is M2, and may further indicate that an input data dimension/size of "Vector quant." is K1 and an output (after selection) data dimension/size is K2, and so on (Note: If a dimension size is not indicated, the UE may alternatively determine input and output sizes of a module, and an output size of a preceding module is equal to an input size of a subsequent module).

The foregoing first device is referred to as a first device 1, and the network device may further configure data processing module configurations for a plurality of first devices. For example, the network device may further configure a data processing module configuration for a first device 2, and send a data processing module configuration to the first device 2.

For example, the data processing module configuration of the first device 2 shown in Table 20 includes a data processing module combination for sensing data (Sensing Config {...}), and a data processing module combination for AI feature data (AI feature Config {...}). The data processing module combination (Sensing Config {...}) corresponds to row 2 in Table 12, and the data processing module combination (AI feature Config {...}) corresponds to row 4 in Table 12. According to this application, different compression manners may be configured for sensing data compression of the first device 1 and the first device 2 by using different module combinations, and compression manners for different types of data may also be configured for different first devices, so that compression is more flexible and a process is more simplified.

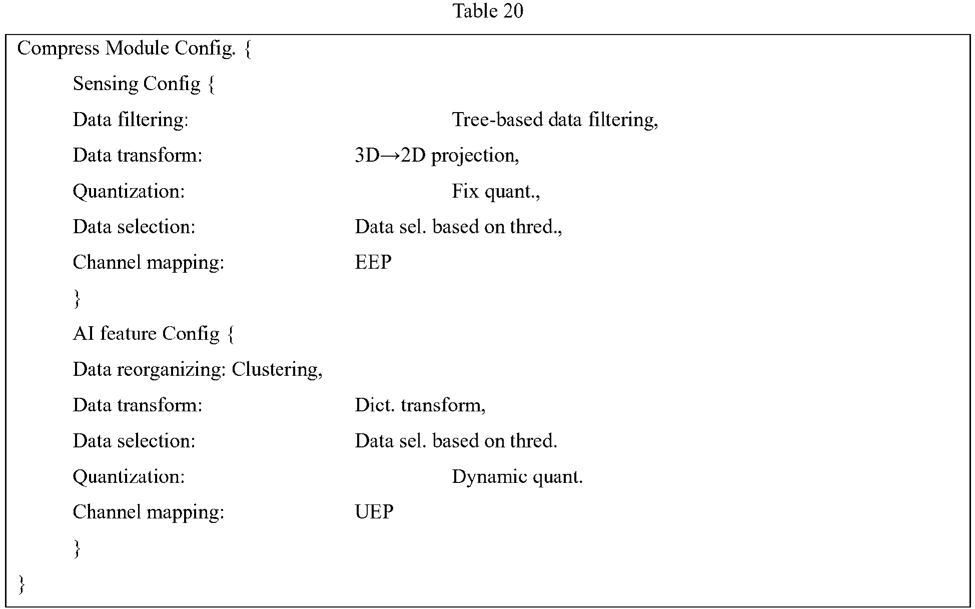

Optionally, if the first device 1 is configured with a data processing module pool, for example, the data processing module pool shown in Table 11, the data processing module configuration of the first device 1 may also reference a module index in the data processing module pool. In this case, Table 17 may be represented as Table 21.

**Table 21**

| |
|---|
| ``` Compress Module Config. { Sensing Config {1, 6, 10, 13, 17} H Config {1, 5, 8, 13, 12, 17} ``` |

Similarly, if the first device 2 is configured with a data processing module pool, for example, the data processing module pool shown in Table 11, the data processing module configuration of the first device 2 may also reference a module index in the data processing module pool. In this case, Table 20 may be represented as Table 22.

**Table 22**

| |
|---|
| ``` Compress Module Config. { Sensing Config {4, 9, 13, 10, 17} AI feature Config {3, 6, 10, 15, 16} ``` |

The foregoing describes a procedure in which the network device configures the data processing modules for the first device.

In another possible implementation, the data processing module of the first device is configured by the second device. In this case, the first device may send the capability information of the first device to the second device, and receive the data processing module configuration information from the second device.

In still another possible implementation, the data processing module of the first device is configured by the first device. For example, the first device configures the data processing modules, and reports the data processing module configuration to the network device. For a specific format of the data processing module configuration, refer to the foregoing descriptions.

In conclusion, the data processing module configuration may be configured by the network device or the second device, or may be configured by the first device. The data processing module configuration is used to determine one or more data processing modules that compress the to-be-transmitted data, for example, N data processing modules, where N is a natural number greater than 0.

It should be understood that the N data processing modules that compress the to-be-transmitted data and a sequence and parameters of the data processing modules are determined based on a data type of the to-be-transmitted data, a task scenario, and/or the capability of the first device.

S440: The first device compresses the to-be-transmitted data based on the data processing module configuration information, and sends the compressed data to the network device.

Alternatively, the first device may send the compressed data to the second device.

Specifically, the first device may determine, based on the data processing module configuration information, the N data processing modules that compress the to-be-transmitted data, and compress the to-be-transmitted data by using the N data processing modules based on a first sequence and a first compression parameter. The first sequence is a sequence of processing data by the N data processing modules, and the first compression parameter is a parameter used by the N data processing modules to process the data.

It should be understood that for the first device, the N data processing modules, the first sequence, and the first compression parameter may all be obtained based on the data processing module configuration corresponding to the first device. The data processing module configuration is determined by the network device based on a data type of the to-be-transmitted data, a task scenario, and/or the capability of the first device.

The foregoing method describes a procedure in which the network device configures the data processing modules for the first device.

In another possible implementation, when the first device is a network device, the first device may also configure a data processing module pool and data processing modules for itself. In this case, the first device may independently complete a procedure of configuring the data processing module pool and the data processing modules, without requiring to interact with another network device.

The compression procedure is implemented based on a physical-layer data processing module combination, which can greatly reduce standardization costs and terminal design costs. For example, if there are N types of basic data processing modules, k basic data processing modules may be combined to form N^{k} different compression procedures/methods. However, if the data processing module combination manner is not used, the N^{k} compression procedures/methods may require N^{k} configurations, which results in extremely high standardization costs and also makes a terminal design very complex.

The foregoing describes the data processing module pool, the data processing modules, and the corresponding configuration method. It should be understood that validity of the data processing module pool and the data processing modules does not always meet a requirement. Therefore, validity management further needs to be performed on the data processing module pool and the data processing modules, that is, updating the data processing module pool configuration and the data processing module configuration.

The following describes a method for updating the data processing module configuration. Updating the data processing module configuration is updating the data processing module combination, including updating types of the data processing modules, a sequence of the data processing modules, and parameters of the data processing modules. The data processing module update may be configured by the network device or the second device, and sent to the first device through RRC/MAC signaling in a broadcast/multicast/unicast manner, or may be indicated by the first device to the network device or the second device.

Optionally, in a scenario in which the first device communicates with the network device, the data processing module configuration of the first device is updated by the network device or the first device.

Optionally, in a scenario in which the first device communicates with the second device, when the data processing module configuration of the first device is configured by the network device, the network device or the first device updates the data processing module configuration; or when the data processing module configuration of the first device is configured by the second device, the second device or the first device updates the data processing module configuration.

The following uses a scenario in which the first device communicates with the network device as an example to describe the method for updating the data processing module configuration. In this case, the data processing module configuration of the first device is updated by the network device or the first device.

When a first condition is met, the network device or the first device may update the data processing module configuration.

Specifically, the first condition includes one or more of the following conditions:
an update-period condition, a task-scenario condition, a compression-quality condition of data, a mobility condition of the first device, and a user-request condition.

Update-period condition: The network device periodically triggers an update of the data processing module configuration.

Optionally, as shown in FIG. 5, the data processing module configuration information or other signaling may indicate an update period T for the data processing module. Then, at intervals of the period T, the network device sends data processing module update (Compress Module Update) information to periodically adjust a data processing module combination, a data processing module parameter, and the like.

Task-scenario condition: The network device triggers a data processing module update according to a task requirement or task scenario.

Compression-quality condition of data: Quality of compressed data sent by the first device does not meet a requirement.

For example, when the quality of the compressed data reported by the first device changes and does not meet a requirement of a corresponding sensing task, an AI task, a sensing-assisted communication task, or the like, the network device may adjust the data processing module configuration in real time. For example, if the compression quality of the first device is poor (lower quality at a same bit rate), the network device may improve compression efficiency (achieve higher quality at a same bit rate) by replacing uniform quantization (Fix quant.) with dynamic quantization (Dynamic quant.), or by replacing a dictionary in dictionary transform (Dictionary transform) with another dictionary.

Mobility condition of the first device: A location of the first device changes.

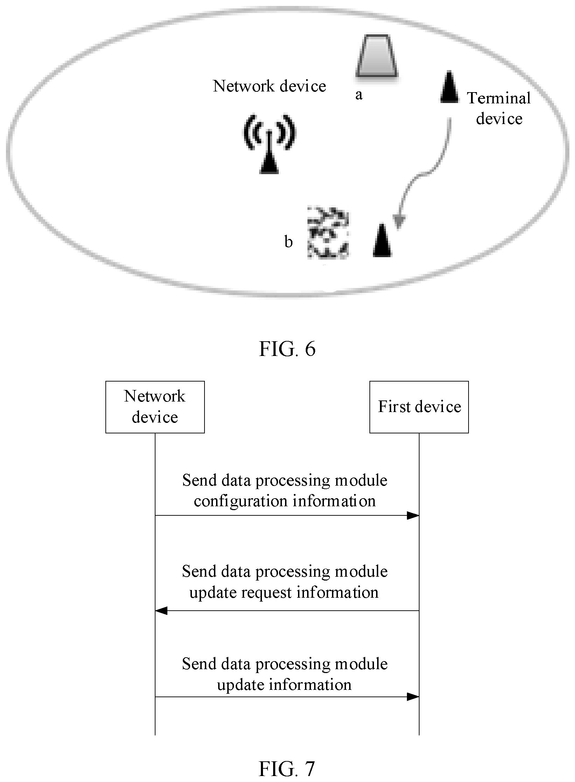

For example, as shown in FIG. 6, when the first device moves from a cell location a to a location b, a surrounding environment changes, and a different compression method should be used for the sensing data. For example, geometric features at the location a are more obvious, and compression by using "three-dimensional to two-dimensional projection (3D→2D projection)" is more appropriate. At the location b, there are some scattered point clouds/reflection points, and compression by using "dictionary transform (Dictionary transform)" is more appropriate. In this case, the network device may trigger a data processing module update procedure. Assuming that a previous data processing module combination for sensing data is row 1 of Table 12, a BS replaces the data processing module configuration for sensing data with row 3 of Table 12 through the data processing module update.

User-request condition: The first device requests to update the data processing module configuration.

For example, as shown in FIG. 7, the first device sends data processing module update request (Compress Module Update Req.) information to the network device. Optionally, the data processing module update request information may carry a reason for the change, for example, a location change, an environment/scenario change, or a change in compression quality. The network device may send the data processing module update to the first device based on the request of the first device.

Based on the foregoing conditions, on the basis of the method shown in FIG. 4, the network device or the first device may trigger the data processing module update, and determine, by using an updated data processing module configuration, a manner of compressing the to-be-transmitted data.

It should be understood that, in a scenario in which the first device communicates with the second device, replacing the network device in the foregoing descriptions with the second device corresponds to an implementation in which the data processing module configuration is updated by the second device or the first device.

The following describes several specific formats of the data processing module update (Compress Module Update) information (that is, one example of second configuration information). It should be understood that there are a plurality of formats of the data processing module update information. This is not limited in this application, and the following is merely an example.

Based on the data processing module configuration shown in Table 17, the data processing module update information described below is updated based on Table 17. That is, the data processing module configuration for sensing data is updated, to determine data processing modules, a sequence, and a compression parameter for compressing the sensing data, which are not completely the same as those in Table 17.

For example, in the data processing module update information shown in Table 23, the data processing module combination for sensing data is completely replaced with a new module combination, that is, content in Sensing Update {...}.

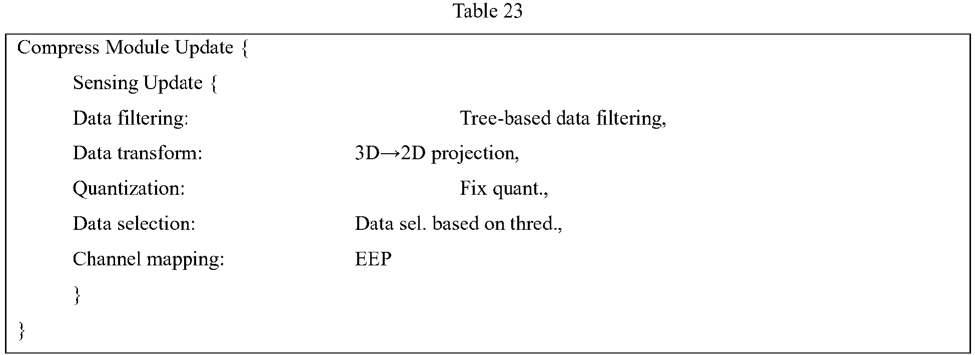

For example, in the data processing module update information shown in Table 24, a sequence of some modules in the data processing module combination for sensing data is adjusted. Specifically, "Quantization: Fix quant.," and "Data selection: Data sel. based on thred." are swapped.

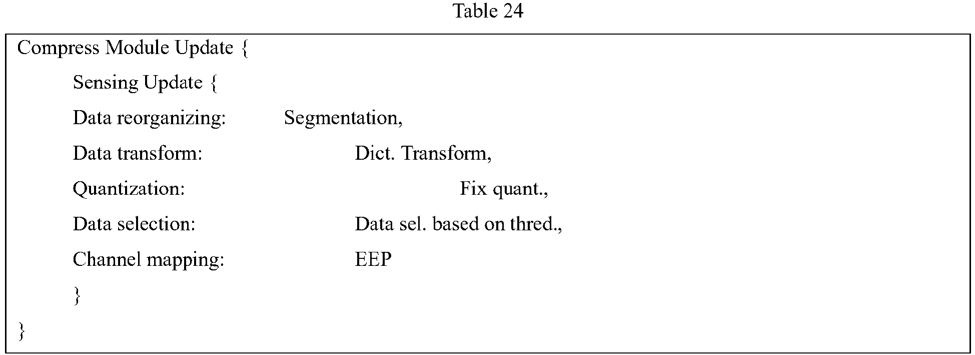

For example, in the data processing module update information shown in Table 25, adjustment is performed based on a module sequence in the original data processing module combination for sensing data. For example, the original data processing module configuration for sensing data in Table 17 includes "Data reorganizing: Segmentation", "Data transform: Dict. Transform", "Data selection: Data sel. based on thred.", "Quantization: Fix quant.", and "Channel mapping: EEP", whose identifiers are 1, 2, 3, 4, and 5, respectively. An updated module sequence may be indicated based on these module identifiers. For example, the data processing module update in Table 25 indicates that a module sequence is changed to 1, 2, 4, 3, 5, which may obtain same effect as the data processing module update in Table 24. Similarly, a protocol may also specify a default data processing module sequence. For example, a sequence of the sensing data processing module configuration used in Table 17 is used as a default sequence. In this case, the data processing module update may indicate an updated module sequence based on identifiers corresponding to the default sequence.

**Table 25**

| |
|---|
| ``` Compress Module Update { Sensing Update {1, 2, 4, 3, 5} } ``` |

For example, in the data processing module update information shown in Table 26, some modules in the data processing module combination for sensing data are replaced. Specifically, a third step "Quantization: Fix quant." is replaced with "Quantization: Dynamic quant.", and a fourth step "Data selection: Data sel. based on thred." is replaced with "Data selection: Data sel. based on bitmap".

**Table 26**

| |
|---|
| ``` Compress Module Update { Sensing Update { Replace step 3: "Quantization: Dynamic quant." Replace step 4: "Data selection: Data sel. based on bitmap" ``` |

For example, in the data processing module update information shown in Table 27, some module parameters in the data processing module combination for sensing data are updated. For example, it may indicate that quantization bits of "Quantization: Fix quant.," are changed from 4 bits to 3 bits, and a transform dictionary of "Data transform: Dict. Transform," is changed from D1 to D2, and so on.

**Table 27**

| |
|---|
| ``` Compress Module Update { Sensing Update { Update "Quantization: Fix quant" parameters {xxxx} } ``` |

Optionally, the data processing module update information may further indicate to enable a new data processing module combination, and/or disable a data processing module combination (for example, a specific data processing module combination is outdated with respect to a current environment of the UE).

It is assumed that the data processing module configuration includes a data processing module combination for sensing data, and the data processing modules are updated on this basis.

For example, as shown in Table 28, a data processing module update-1 and a data processing module update-2 are respectively information updated for a first time and information updated for a second time based on the data processing module configuration. A data processing module combination for AI data is newly added to the data processing module update-1. In this case, after the data processing module update-1, the first device has data processing module combinations for both the sensing data and the AI data. The data processing module combination for sensing data is deleted from the data processing module update-2. In this case, after the data processing module update-2, the first device has only the data processing module combination for the AI data.

**Table 28**

| Data processing module configuration | Data processing module update-1 | Data processing module update-2 |
|---|---|---|
| Compress Module Config. { | Compress Module Update { | Compress Module Update { |
| Sensing Config { | **Add** AI feature Config { | **Remove** Sensing Config |
| ...} | ...} | } |
| } | } | |

If a plurality of data processing module combinations are configured for a same data type in the data processing module configuration, an index may be referenced upon enabling or disabling or upon data compression.

For example, as shown in Table 29, the data processing module update-1 includes two data processing module combinations for the sensing data, that is, a configuration 1 and a configuration 2. In the data processing module update-1, the data processing module configuration 1 for the sensing data is disabled (by directly referencing an index). In this case, after the data processing module update-1, the first device has only one data processing module combination for sensing data. In the data processing module update-2, the data processing module configuration 2 for the sensing data is enabled (by directly referencing an index). In this case, after the data processing module update-2, the first device has two data processing module combinations for the sensing data again.

**Table 29**

| Data processing module configuration | Data processing module update-1 | Data processing module update-2 |
|---|---|---|
| Compress Module Config. { | Compress Module Update { | Compress Module Update { |
| Sensing Config 1 { | **Disable** Sensing Config 1 | **Enable** Sensing Config 1 |
| ...} | } | } |
| Sensing Config 2 { | | |
| ...} | | |
| } | | |

Enabling, disabling, adding, and deleting a data processing module combination as a whole can simplify control signaling and configuration procedures.

If a plurality of data processing module combinations are configured for a same data type, the first device may flexibly select one of them (an index to be used needs to be indicated when compressed data is reported), and the network device may also explicitly indicate which combination is currently to be used. For example, in Table 29, after the data processing module configuration information and the data processing module update-2, the first device has two data processing module combinations for sensing data. In this case, when compressing the sensing data, the first device may indicate whether the configuration 1 or the configuration 2 is used for the sensing data compressed by the first device. The indication may be sent to the network device together with the compressed data, or may be indicated to the network device by using a separate message. Similarly, the network device may alternatively send a configuration message to the first device, to indicate whether the first device currently applies the configuration 1 or the configuration 2 to compress the sensing data.

Before the data processing module update, the first device compresses to-be-transmitted data (for example, the sensing data) by using the N data processing modules based on the first sequence and the first compression parameter. To-be-transmitted sensing data before the update is referred to as first data, and to-be-transmitted perception data after the update is referred to as third data. The first device may determine, based on the data processing module update information described above, X data processing modules that compress the third data, and compress the third data by using the X data processing modules based on a third sequence and a third compression parameter.

Optionally, both the third data and the first data are sensing data and are data of a same type. By using the foregoing data processing module update procedures, the data processing module update may be performed on the data of the same type.

Optionally, both the third data and the first data are data of a same application, and the data processing module update may be performed on the data of the same application based on the foregoing data processing module update procedures. The data of the same application may be understood as data of a same scenario, data of a same task, data of devices with a same capability, or the like.

It should be understood that the X data processing modules, the third sequence, and the third compression parameter may all be obtained based on the data processing module update information corresponding to the first device.

Optionally, in addition to updating the data processing module combination for sensing data, the data processing module update information may further update a data processing module combination for another type of data (that is, one example of second data, such as channel data or AI data).

In other words, the data processing module update information may be further used to determine Y data processing modules that compress the data of the another type, a fourth sequence, and/or a fourth compression parameter.

Similar to the data processing module update, the data processing module pool may also be updated. The data processing module pool update (Compress Module Pool Update) may be configured by the first device; or may be configured by the network device or the second device and sent to the first device through RRC/MAC signaling in a broadcast/multicast/unicast manner.

Optionally, updated content of the data processing module pool includes a data processing module type, a data processing module parameter, and the like. For an update manner of the data processing module pool, refer to the data processing module update. For example, the network device periodically triggers an update, or the first device requests an update from the network device.

The following describes a method for collecting training data of the data processing module.

It should be understood that parameters of some data processing modules need to be updated based on some training data (Train data). For example, if the network device determines the data processing modules, and some modules need to be updated based on data from the first device, the network device may periodically/aperiodically trigger collection of related data. For example, a dictionary in dictionary transform, a codebook in vector quant., a semantic model in semantic filtering, and the like may all need to be updated in real time based on some data of the first device, to achieve better compression performance.

Training data for the data processing module may be original data, or may be processed data (for example, transformed data, or a result obtained after feature extraction, that is, an intermediate result), or may be compressed data (the training data may be compressed using same or different compression manners and compression degrees as those applied to native data; and the compression manner of the training data may be agreed in advance, or may be configured by the network device or the second device for the first device, or may be indicated by the first device to the network device).

Training data collection may be triggered by the network device or the second device, or may be triggered by the first device. For example, when it is determined that the training data collection needs to be triggered, training data collection request (Compress Module Train Data Req.) information of the data processing module may be configured by the network device or the second device, and is sent to the first device through RRC/MAC signaling in a broadcast/multicast/unicast manner.

Optionally, a training data collection request (Compress Module Train Data Req.) includes a type of training data (sensing training data, AI training data, channel H training data, and the like) that needs to be fed back, a feedback time (a feedback period, a feedback interval, and a feedback triggering condition, such as compression quality being lower than a threshold, or a moving speed exceeding a threshold), a feedback coding parameter (for example, a compression method and a compression parameter of feedback data), and the like.

The network device or the first device (or the second device and the first device) may periodically/aperiodically trigger the training data collection (for example, trigger based on a requirement/scenario, or trigger based on compression quality), or may perform training or updating based on native data collected by the network device (or the second device) (in this case, an explicit training data collection procedure is not required. That is, the network device (or the second device) may update the data processing module parameter in real time based on the received sensing/AI/channel H data, and use the received native data as training data, without requiring additional training data).

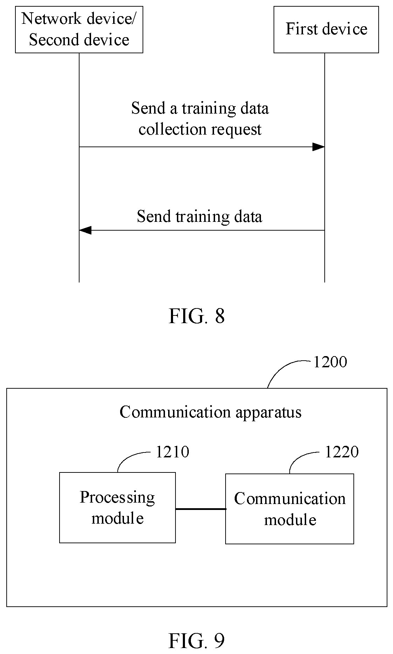

As shown in FIG. 8, after receiving the training data collection request, the first device feeds back corresponding training data. The feedback may be provided once or a plurality of times, and training data periods/feedback times and content fed back by different first devices may be different. For example, a feedback period of a first device 1 is T1, a feedback period of a first device 2 is T2, and T1 and T2 are different. For another example, the first device 1 feeds back sensing and AI training data, the first device 2 feeds back channel H training data, and the first device 3 feeds back sensing and H training data.

Optionally, the first device may actively feed back or send the training data.

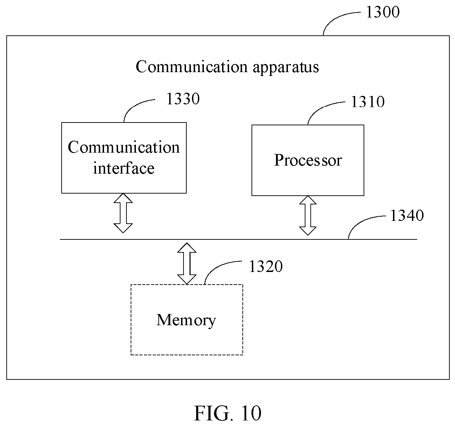

The foregoing describes in detail embodiments on a communication method side in this application with reference to FIG. 1 to FIG. 8. The following describes in detail embodiments on a communication apparatus side in this application with reference to FIG. 9 and FIG. 10. It should be understood that descriptions of the apparatus embodiments correspond to the descriptions of the method embodiments, and therefore, for a part that is not described in detail, refer to the foregoing method embodiments.

FIG. 9 is a diagram of a communication apparatus according to an embodiment of this application. As shown in FIG. 9, the communication apparatus 1200 includes a processing module 1210 and a communication module 1220. The communication apparatus 1200 may be a terminal device, or may be a communication apparatus, for example, a chip, a chip system, or a circuit, that is used in a terminal device or used in combination with the terminal device and that can implement a method performed by the terminal device. Alternatively, the communication apparatus 1200 may be a network device, or may be a communication apparatus, for example, a chip, a chip system, or a circuit, that is used in a network device or used in combination with the network device and that can implement a method performed by the network device.

The communication module may also be referred to as a transceiver module, a transceiver, a transceiver device, a transceiver apparatus, or the like. The processing module may also be referred to as a processor, a processing board, a processing unit, a processing apparatus, or the like. Optionally, the communication module is configured to perform a sending operation and a receiving operation of the terminal device or the network device in the foregoing methods. A component configured to implement a receiving function in the communication module may be considered as a receiving unit, and a component configured to implement a sending function in the communication module may be considered as a sending unit. In other words, the communication module includes the receiving unit and the sending unit.

When the communication apparatus 1200 is used in the terminal device, the processing module 1210 may be configured to implement processing functions of the terminal device in the foregoing embodiments, and the communication module 1220 may be configured to implement receiving and sending functions of the terminal device in the foregoing embodiments.

When the communication apparatus 1200 is used in the network device, the processing module 1210 may be configured to implement processing functions of the network device in the foregoing embodiments, and the communication module 1220 may be configured to implement receiving and sending functions of the terminal device in the foregoing embodiments.

In addition, it should be noted that the communication module and/or the processing module may be implemented using a virtual module. For example, the processing module may be implemented using a software functional unit or a virtual apparatus, and the communication module may be implemented using a software functional or virtual apparatus. Alternatively, the processing module or the communication module may be implemented by using a physical apparatus. For example, if the apparatus is implemented by using a chip/circuit (for example, an integrated circuit or a logic circuit), the communication module may be an input/output circuit and/or a communication interface, and performs an input operation (corresponding to the foregoing receiving operation) and an output operation (corresponding to the foregoing sending operation). The processing module is an integrated processor, a microprocessor, or a circuit (for example, an integrated circuit or a logic circuit).

In this application, division into modules is an example, and is merely logical function division. In actual implementation, another division manner may be used. In addition, functional modules in examples of this application may be integrated into one processor, each of the modules may exist alone physically, or two or more modules may be integrated into one module. The integrated module may be implemented in a form of hardware, or may be implemented in a form of a software functional module.

FIG. 10 is a diagram of another communication apparatus according to an embodiment of this application. As shown in FIG. 10, optionally, the communication apparatus 1300 may be a chip or a chip system. Optionally, the chip system in this application may include a chip, or may include a chip and another discrete device.

The communication apparatus 1300 may be configured to implement a function of any device (for example, the terminal device or the network device) in the communication system described in the foregoing examples. The communication apparatus 1300 may include at least one processor 1310. Optionally, the processor 1310 is coupled to a memory. The memory may be located in the apparatus. Alternatively, the memory may be integrated with the processor. Alternatively, the memory may be located outside the apparatus. For example, the communication apparatus 1300 may further include at least one memory 1320. The memory 1320 stores a computer program, a computer program or instructions, and/or data that are/is necessary for implementing any one of the foregoing examples. The processor 1310 may execute the computer program stored in the memory 1320, to perform the method in any one of the foregoing examples.

The communication apparatus 1300 may further include a communication interface 1330. The communication apparatus 1300 may perform information interaction with another device through the communication interface 1330. For example, the communication interface 1330 may be a transceiver, a circuit, a bus, a module, a pin, or a communication interface of another type. When the communication apparatus 1300 is a chip-type apparatus or circuit, the communication interface 1330 in the apparatus 1300 may alternatively be an input/output circuit, and may input information (or referred to as receiving information) and output information (or referred to as sending information). The processor 1310 is an integrated processor, a microprocessor, an integrated circuit, a logic circuit, or the like. The processor may determine output information based on input information.

The coupling in this application is indirect coupling or a communication connection between apparatuses, units, or modules for information exchange between the apparatuses, the units, or the modules, and may be in electrical, mechanical, or other forms. The processor 1310 may cooperate with the memory 1320 and the communication interface 1330. A specific connection medium between the processor 1310, the memory 1320, and the communication interface 1330 is not limited in this application.

Optionally, as shown in FIG. 10, the processor 1310, the memory 1320, and the communication interface 1330 are connected to each other through a bus 1340. Optionally, the bus may include a type of bus such as an address bus, a data bus, or a control bus. In addition, for ease of representation, FIG. 10 shows one bus 1340, but this does not mean that there is only one bus or only one type of bus.

It should be understood that the processor mentioned in embodiments of this application may be the following device or a part of circuits configured for a processing function in the following device: a central processing unit (central processing unit, CPU) or another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It should be further understood that the memory mentioned in embodiments of this application may be a volatile memory and/or a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM). For example, the RAM may be used as an external cache. As an example instead of a limitation, the RAM may include the following plurality of forms: a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

It should be noted that when the processor is a general-purpose processor, a DSP, an ASIC, an FPGA or another programmable logic device, a discrete gate or a transistor logic device, or a discrete hardware component, the memory (storage module) may be integrated into the processor.

It should further be noted that the memory described in this specification is intended to include, but is not limited to, these and any other appropriate type of memory.

An embodiment of this application further provides a computer-readable storage medium. The computer-readable storage medium stores computer instructions used to implement the methods performed by the terminal device and the network device in the foregoing method embodiments.

An embodiment of this application further provides a computer program product, including instructions. When the instructions are executed by a computer, the methods performed by the terminal device and the network device in the foregoing method embodiments are implemented.

An embodiment of this application further provides a communication system. The communication system includes the terminal device and the network device in the foregoing embodiments.

For explanations and beneficial effects of related content in any one of the apparatuses provided above, refer to the corresponding method embodiments provided above. Details are not described herein again.

For ease of understanding the foregoing embodiments provided in this application, the following descriptions are provided.
(1) In this application, unless otherwise stated or if there is a logic conflict, terms and/or descriptions in different embodiments are consistent and may be mutually referenced, and technical features in different embodiments may be combined into a new embodiment based on an internal logical relationship thereof.
(2) In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. In text descriptions of this application, the character "/" usually indicates an "or" relationship between associated objects. "At least one of the following" or a similar expression thereof indicates any combination of these items, including a single item or any combination of a plurality of items. For example, at least one of a, b, and c may indicate a, b, c, a and b, a and c, b and c, or a, b, and c. Each of a, b, and c may be singular or plural.
(3) Ordinal numbers such as "first" and "second" mentioned in embodiments of this application are used to distinguish between a plurality of objects, but are not used to limit sizes, content, sequences, time sequences, priorities, importance, or the like of the plurality of objects. For example, first indication information and second indication information may be same information, or may be different information. In addition, such names do not indicate that the two messages are different in content, sizes, application scenarios, transmit ends/receive ends, priorities, importance, or the like. In addition, step numbers in embodiments described in this application are merely intended to distinguish between different steps, but are not intended to limit a sequence of the steps.
(4) In this application, descriptions such as "when...", "in a case that...", and "if" all mean that a device performs corresponding processing in an objective case and do not limit time, and the device is not required to perform a determining action during implementation. This does not mean that there is another limitation.
(5) In this application, "indicate" may include a direct indication and an indirect indication. When a piece of indication information is described to indicate A, the indication information may directly indicate A or indirectly indicate A, but it does not indicate that the indication information definitely carries A.

Indication manners in embodiments of this application should be understood as covering various methods that can enable a to-be-indicated party to learn of to-be-indicated information. The to-be-indicated information may be sent as a whole, or may be divided into a plurality of pieces of sub-information for separate sending. In addition, sending periodicities and/or sending occasions of the sub-information may be the same or may be different. An example sending method is not limited in embodiments of this application.

The "indication information" in embodiments of this application may be an explicit indication, to be specific, a direct indication by using signaling, or an indication obtained based on a parameter indicated by signaling in combination with another rule or another parameter or obtained through deduction; or may be an implicit indication, to be specific, an indication obtained based on a rule, a relationship, or another parameter or obtained through deduction. This is not specifically limited in this application.

(6) The "protocol" in this application may be a standard protocol in the communication field, for example, may include a fourth generation (4^{th} generation, 4G) network protocol, a fifth generation (5^{th} generation, 5G) network protocol, an NR protocol, a 5.5G network protocol, a sixth generation (6^{th} generation, 6G) network protocol, and a related protocol applied to a future communication system. This is not limited in this application.

(7) In this application, "communication" may also be described as "data transmission", "information transmission", "data processing", or the like. "Transmission" includes "sending" and "receiving".

(8) In this application, "sending information to XX (a device)" may be understood as that a destination of the information is the device, and may include directly or indirectly sending the information to the device. "Receiving information from XX (a device) or receiving information that is from XX (a device)" may be understood as that a source of the information is the device, and may include directly or indirectly receiving the information from the device. Information may undergo necessary processing, for example, a format change, between the source for sending the information and the destination. However, the destination may understand valid information from the source.

(9) The terms "include", "have", and any other variant thereof are intended to cover a non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

In various embodiments of this application, sequence numbers of the foregoing processes do not mean execution sequences. The execution sequences of the processes should be determined based on functions and internal logic of the processes, and should not be construed as any limitation on the implementation processes of embodiments of this application.

In this application, without a logical contradiction, mutual reference can be made between examples. For example, mutual reference can be made between methods and/or terms in the method embodiments. For example, mutual reference can be made between functions and/or terms in the apparatus embodiments. For example, mutual reference can be made between functions and/or terms in the apparatus examples and the method examples.

It should be understood that, in some of the foregoing embodiments, a device in an existing network architecture is mainly used as an example for description, and a specific form of the device is not limited in embodiments of this application. For example, all devices that can implement a same function in the future are applicable to embodiments of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the mutual coupling or direct coupling or communication connection shown or discussed may be indirect coupling or communication connection through some interfaces, apparatuses, or units, and may be in electrical, mechanical, or other forms.

The units described as separate parts may or may not be physically separate, and parts displayed as units may or may not be physical units, may be located in one location, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a ROM, a RAM, a magnetic disk, or an optical disc.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A communication method, comprising:
compressing first data by using N preconfigured data processing modules, wherein the compression corresponds to at least one data processing operation, a combination of functions of the N data processing modules comprises the at least one data processing operation, the N data processing modules are determined based on the first data, a task scenario, and/or a capability of a first device, and N is a natural number greater than 0; and
sending the compressed first data.

2. The method according to claim 1, wherein the N data processing modules are deployed at a physical layer.

3. The method according to claim 1 or 2, wherein compressing the first data by using the N preconfigured data processing modules comprises:
compressing the first data by using the N data processing modules based on a first sequence and a first compression parameter, wherein the first sequence is a sequence of processing data by the N data processing modules, and the first compression parameter is a parameter used by the N data processing modules to process data.

4. The method according to claim 3, wherein the first sequence and/or the first compression parameter is determined based on the first data, the task scenario, and/or the capability of the first device.

5. The method according to any one of claims 1 to 4, wherein the N data processing modules are data processing modules in a preconfigured data processing module pool.

6. The method according to claim 5, wherein the data processing module pool comprises M data processing module sets, the data processing module set comprises at least one data processing module, the N data processing modules are data processing modules in the M data processing module sets, and data processing modules in each of the M data processing module sets perform a same data processing function.

7. The method according to claim 5 or 6, wherein the N data processing modules that compress the first data are determined from the data processing module pool based on the first data, the task scenario, and/or the capability of the first device.

8. The method according to any one of claims 1 to 7, wherein the method further comprises:
receiving data processing module pool configuration information or capability information of a second device, and determining the data processing module pool based on the data processing module pool configuration information or the capability information of the second device.

9. The method according to any one of claims 1 to 7, wherein the method further comprises:
sending data processing module pool configuration information or capability information of the first device, wherein the data processing module pool configuration information or the capability information of the first device is used to determine the data processing module pool.

10. The method according to any one of claims 1 to 9, wherein the method further comprises:
determining, based on first configuration information, the N data processing modules that compress the first data, the first sequence, and/or the first compression parameter, wherein the first sequence is a sequence of processing data by the N data processing modules, and the first compression parameter is a parameter used by the N data processing modules to process data.

11. The method according to claim 10, wherein the method further comprises:
receiving or sending the first configuration information.

12. The method according to claim 10 or 11, wherein the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

13. The method according to any one of claims 1 to 12, wherein the method further comprises:
determining, based on second configuration information, X data processing modules that compress third data, a third sequence, and/or a third compression parameter, wherein the third sequence is a sequence of processing data by the X data processing modules, the third compression parameter is a parameter used by the X data processing modules to process data, and the third data and the first data are data of a same type or data of a same application, wherein
the X data processing modules are not completely the same as the N data processing modules, and/or the third sequence is not completely the same as the first sequence, and/or the first compression parameter is not completely the same as the third compression parameter.

14. The method according to claim 13, wherein the method further comprises:
compressing the third data by using the X data processing modules.

15. The method according to claim 14, wherein compressing the third data by using the X data processing modules comprises:
compressing the third data by using the X data processing modules based on the third sequence and the third compression parameter.

16. The method according to any one of claims 13 to 15, wherein the method further comprises:
receiving or sending the second configuration information.

17. The method according to any one of claims 13 to 16, wherein the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

18. The method according to any one of claims 1 to 17, wherein the method further comprises:
sending first training data, wherein the first training data comprises training data corresponding to the first data.

19. The method according to claim 18, wherein the method further comprises:
receiving first request information, wherein the first request information is used to request to obtain the first training data.

20. A communication method, comprising:
sending first configuration information, wherein the first configuration information is used to determine N preconfigured data processing modules that compress first data, a first sequence, and/or a first compression parameter, the compression corresponds to at least one data processing operation, a combination of functions of the N data processing modules comprises the at least one data processing operation, N is a natural number greater than 0, the first sequence is a sequence of processing data by the N data processing modules, the first compression parameter is a parameter used by the N data processing modules to process data, and the N data processing modules, the first sequence, and/or the first compression parameter are/is determined based on the first data, a task scenario, and/or a capability of the first device.

21. The method according to claim 20, wherein the data processing modules are deployed at a physical layer.

22. The method according to claim 20 or 21, wherein the method further comprises:
determining the first configuration information based on the first data, the task scenario, and/or the capability of the first device.

23. The method according to any one of claims 20 to 22, wherein the method further comprises:
receiving capability information of the first device.

24. The method according to any one of claims 20 to 23, wherein the N data processing modules are data processing modules in a preconfigured data processing module pool.

25. The method according to claim 24, wherein the data processing module pool comprises M data processing module sets, the data processing module set comprises at least one data processing module, the N data processing modules are data processing modules in the M data processing module sets, and data processing modules in each of the M data processing module sets perform a same data processing function.

26. The method according to claim 24 or 25, wherein the method further comprises:
sending data processing module pool configuration information.

27. The method according to any one of claims 20 to 26, wherein the first configuration information is further used to determine L data processing modules that compress second data, a second sequence, and/or a second compression parameter, the second sequence is a sequence of processing data by the L data processing modules, and the second compression parameter is a parameter used by the L data processing modules to process data.

28. The method according to any one of claims 20 to 27, wherein the method further comprises:
sending second configuration information, wherein the second configuration information is used to determine X data processing modules that compress third data, a third sequence, and/or a third compression parameter, the third sequence is a sequence of processing data by the X data processing modules, the third compression parameter is a parameter used by the X data processing modules to process data, and the third data and the first data are data of a same type or data of a same application, wherein
the X data processing modules are not completely the same as the N data processing modules, and/or the third sequence is not completely the same as the first sequence, and/or the first compression parameter is not completely the same as the third compression parameter.

29. The method according to claim 28, wherein the method further comprises:
determining the second configuration information based on the first data, the task scenario, and/or the capability of the first device.

30. The method according to claim 28 or 29, wherein the second configuration information is further used to determine Y data processing modules that compress the second data, a fourth sequence, and/or a fourth compression parameter, the fourth sequence is a sequence of processing data by the Y data processing modules, and the fourth compression parameter is a parameter used by the Y data processing modules to process data.

31. The method according to claim 29 or 30, wherein determining the second configuration information based on the first data, the task scenario, and/or the capability of the first device comprises:
when a first condition is met, determining the second configuration information based on the first data, the task scenario, and/or the capability of the first device, wherein the first condition comprises one or more of the following conditions:
an update-period condition, a task-scenario condition, a compression-quality condition of the first data, a mobility condition of the first device, and a user-request condition.

32. The method according to any one of claims 20 to 31, wherein the method further comprises:
receiving first training data, wherein the first training data comprises training data corresponding to the first data.

33. The method according to claim 32, wherein the method further comprises:
sending first request information, wherein the first request information is used to request to obtain the first training data.

34. A communication apparatus, comprising:
a unit configured to implement the method according to any one of claims 1 to 19, or a unit configured to implement the method according to any one of claims 20 to 33.

35. A computer-readable storage medium, wherein the computer-readable storage medium stores a computer program or instructions, and when the computer program or the instructions are run,
the method according to any one of claims 1 to 19 is performed, or
the method according to any one of claims 20 to 33 is performed.
